(19) **Europäisches Patentamt / European Patent Office / Office européen des brevets**

(11) **EP 2 902 528 B1**

(12) # EUROPEAN PATENT SPECIFICATION

(45) Date of publication and mention
of the grant of the patent:
**29.06.2016 Bulletin 2016/26**

(51) Int Cl.:
**C23C 16/40** [(2006.01)]    **C23C 16/455** [(2006.01)]

(21) Application number: **14153355.4**

(22) Date of filing: **30.01.2014**

(54) **Alumina coated cutting tool with zigzag alumina grain boundaries**

Aluminiumbeschichtetes Schneidwerkzeug mit Zickzack-Aluminiumkorngrenzen

Outil de coupe revêtu d'alumine avec limites de grains d'alumine en zigzag

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.08.2015 Bulletin 2015/32**

(73) Proprietor: **WALTER AG**
**72072 Tübingen (DE)**

(72) Inventors:
• **Ruppi, Sakari**
**72070 Tübingen (DE)**

• **Stiens, Dirk**
**72762 Reutlingen (DE)**

(74) Representative: **WSL Patentanwälte Partnerschaft mbB**
**Kaiser-Friedrich-Ring 98**
**65185 Wiesbaden (DE)**

(56) References cited:
**WO-A1-2013/038000    US-A- 5 876 860**

**Description**

FIELD OF THE INVENTION

The present invention relates to a coated cutting tool insert and a method of manufacturing the same, the coated cutting tool insert consisting of a substrate of cemented carbide, cermet, ceramics, steel or cubic boron nitride at least partially coated with a coating of a total thickness of a maximum of 60 $\mu$m consisting of one or more refractory layers comprising an outer wear resistant layer of $\alpha$-Al$_2$O$_3$ of a thickness of 2 to 45 $\mu$m deposited by chemical vapour deposition (CVD).

BACKGROUND OF THE INVENTION

The control of the $\alpha$-Al$_2$O$_3$ polymorph in industrial scale was achieved in the beginning of the 1990's with commercial products based on US patent 5,137,774. US 5,654,035, US 5,980,988, US 7,442,431 and US 5,863,640 describe the deposition of $\alpha$-Al$_2$O$_3$ coatings with preferred fiber textures. US 6,333,103 describes a modified method to control the nucleation and growth of $\alpha$-Al$_2$O$_3$ on the (1 0 10) plane. US 6,869,668 describes a method to obtain a strong (1 0 0) texture in $\alpha$-Al$_2$O$_3$ using ZrCl$_4$ as a texture modifying agent. The prior-art processes discussed above use deposition temperatures of about 1000 °C. US 7,094,447 describes a technique to achieve a pronounced (0 1 2) texture. Deposition techniques to produce pronounced (1 0 4) and (1 1 6) textures are disclosed in US 7,442,432 and US 7,455,900, respectively. US 7,993,742 and US 7,923,101 disclose (0 0 1) textured alumina layers. The (0 1 2), (1 0 4) and (0 0 1) textured alumina layers are compared and the (0 0 1) texture is found superior over the other textures. In the above-mentioned disclosures the textures of the $\alpha$-Al$_2$O$_3$ layers were determined by using XRD and quantified by calculating the texture coefficients (TC) using the Harris formula. In US 7,763,346 and US 7,201,956 EBSD has been used to define the (0 0 1) texture, and the texture is quantified by the inclination of the basal (0 0 1) plane with respect to the coating surface. Textured $\alpha$-Al$_2$O$_3$ layers are composed of columnar grains and the $\alpha$-Al$_2$O$_3$ grains are terminated by facets having a relatively large angle to the substrate surface resulting in a rough surface morphology.
US 7,923,101 describes some degree of flattening of the surface of an $\alpha$-Al$_2$O$_3$ layer with a (0 0 1) texture. US 2012/003452 describes that flat-top surfaces have been obtained in $\alpha$-Al$_2$O$_3$ layers containing one or more elements selected from a group consisting of Ti, Y, Zr, Cr and B. These layers are deposited on an $\alpha$-Al$_2$O$_3$ layer, which in turn is deposited on a heat-treated thin Al$_2$O$_3$ film.
US 7,597,511 discloses a surface-coated cutting tool comprising a substrate of cemented carbide or titanium-carbonitride-based cermet with a hard coating layer including a lower layer of a Ti compound with a total average layer thickness of 3 to 20 $\mu$m, and an upper AlZrO layer being formed in a 2-step CVD process requiring ZrCl$_4$, the upper layer being described as "reformed" AlZrO layer. The "reformed" AlZrO layer was shown to have a structure with crystal grains having an even polygonal shape with a large particle size in the plane perpendicular to the thickness direction and an elongate shape in the thickness direction with an even surface. The coating is described to exhibit good cutting performance, however, the deposition of Zr oxide in addition to Al oxide is generally known to increase production costs and putting high demands on operational safety due to self-flammability of freshly polished Zr.
WO2013/038000 A1 discloses a cutting tool with an alpha alumina coating made by a CVD method. The document emphasizes the importance of the properties of the grain boundaries.

OBJECT OF THE INVENTION

It was an object of the present invention to provide a coated cutting tool insert with an $\alpha$-Al$_2$O$_3$ comprising coating showing improved mechanical properties, especially enhanced flank wear resistance and edge-chipping resistance, being important in many metal cutting applications, especially in cutting of cast irons.

DESCRIPTION OF THE INVENTION

According to the present invention there is provided a coated cutting tool insert consisting of a substrate of cemented carbide, cermet, ceramics, steel or cubic boron nitride having deposited thereon a coating of a total thickness of a maximum of 60 $\mu$m consisting of one or more refractory layers comprising an outer wear resistant layer of $\alpha$-Al$_2$O$_3$ of a thickness of 2 to 45 $\mu$m deposited by chemical vapour deposition (CVD), wherein
when observed in a SEM microphotograph of a cross section of the $\alpha$-Al$_2$O$_3$ layer,
the $\alpha$-Al$_2$O$_3$ layer has an essentially columnar $\alpha$-Al$_2$O$_3$ grain structure, and
the grain boundaries of at least 1 out of 25 $\alpha$-Al$_2$O$_3$ grains, preferably at least 5 out of 25 $\alpha$-Al$_2$O$_3$ grains, more preferably at least 15 out of 25 $\alpha$-Al$_2$O$_3$ grains, along the length of the grain boundaries, undergo at least 3, preferably at least 4, more preferably at least 5, directional changes, wherein each directional change of two neighbouring sections of the same grain boundary is at an angle of from 15 to 165 degrees, preferably from 30 to 150 degrees, more preferably from 45 to 135 degrees.

According to the present invention there is also provided a method of manufacturing a coated cutting tool insert comprising the steps of coating a substrate of cemented carbide, cermet, ceramics, steel or cubic boron nitride with a coating of a total thickness of a maximum of 60 $\mu$m consisting of one or more refractory layers comprising an outer wear resistant layer of $\alpha$-Al$_2$O$_3$ of a thickness of 2 to 45 $\mu$m deposited by chemical vapour deposition (CVD) from a reaction gas mixture comprising H$_2$, CO$_2$, AlCl$_3$, HCl and X, with X being selected from H$_2$S, SF$_6$, SO$_2$ and combinations thereof, and the reaction gas mixture further optionally comprising additions of N$_2$, Ar, CO or combinations thereof, wherein the deposition process of the $\alpha$-Al$_2$O$_3$ layer comprises the steps of periodically changing the process conditions to deposit $\alpha$-Al$_2$O$_3$ at least 3 times, the process conditions being selected from those that, when applied to deposit a single $\alpha$-Al$_2$O$_3$ layer of a thickness of at least 4 $\mu$m, are useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2) and defined as follows:

$$TC(h\,k\,l) = \frac{I(h\,k\,l)}{I_0(h\,k\,l)}\left[\frac{1}{n}\sum_{n-1}^{n}\frac{I(hkl)}{I_0(hkl)}\right]^{-1}$$

wherein

I (h k l) = measured intensity of the (hkl) reflection
I$_0$ (h k l) = standard intensity of the standard powder diffraction data according to JCPDF-card no. 42-1468
n = number of reflections used in the calculation, whereby the (hkl) reflections used are: (0 1 2), (1 0 4), (1 1 0), (1 1 3), (1 1 6), (3 0 0) and (0 0 12),

wherein a change from one process condition to another process condition results in a directional change of the growth direction of $\alpha$-Al$_2$O$_3$ grain boundaries, wherein each directional change of two neighbouring sections of the same grain boundary is at an angle of from 15 to 165 degrees, preferably from 30 to 150 degrees, more preferably from 45 to 135 degrees, observable in a SEM microphotograph of a cross section of the $\alpha$-Al$_2$O$_3$ layer for at least 1 out of 25 $\alpha$-Al$_2$O$_3$ grains, preferably at least 5 out of 25 $\alpha$-Al$_2$O$_3$ grains, more preferably at least 15 out of 25 $\alpha$-Al$_2$O$_3$ grains.

In addition to the fiber texture of a coating of a coated cutting tool insert, there are further, still not fully utilized, material properties, which strongly affect the properties of a coating, such as the properties of the grain boundaries. Grain boundaries have a significant influence on material properties, such as grain growth, creep, diffusion, electrical, optical and mechanical properties. Important properties to be considered are, for example, the density of grain boundaries in the material, the chemical composition of the interface and the crystallography, i.e. the grain boundary plane orientations and grain misorientation. The present invention provides a new method to modify or engineer the grain boundaries of $\alpha$-Al$_2$O$_3$ coatings. Prior art $\alpha$-Al$_2$O$_3$ grains are essentially columnar with straight grain boundaries, whereas the present invention provides grain boundaries changing their growth direction several times along the length of the columnar $\alpha$-Al$_2$O$_3$ grains, herein so-called "zigzag" boundaries. The "zigzag" boundaries of the present invention enhance the grain boundary strength, and thus, the mechanical properties of the coating. According to the present invention the "zigzag" boundaries can, for example, be described by triangle forms, saw tooth forms, square wave forms or sine wave forms and combinations of these, whereby the wavelengths and amplitudes of the "zigzag" boundaries being from about 0.05 $\mu$m to several $\mu$m. Thus, the directional change of the grain boundary growth direction must not necessarily form a sharp angle. It is clear for the skilled person, and encompassed by the present invention, that such a directional change may occur also in a curved manner. Independent of the shape of the directional change between two neighbouring sections of the same grain boundary, the directional change defines an angle between these two neighbouring sections of from 15 to 165 degrees. If the directional change occurs in a curved manner, the angle of the directional change is the angle between the first essentially straight regions of the two neighbouring sections next to the point or region of the directional change.

The overall fiber texture of the $\alpha$-Al$_2$O$_3$ layer of the present invention is usually determined by the first process conditions to deposit an $\alpha$-Al$_2$O$_3$ layer, even though the process conditions are periodically changed during the process to deposit the entire $\alpha$-Al$_2$O$_3$ layer.

It has surprisingly been found that a very smooth surface morphology can be obtained by the deposition method of the present invention. The method of the present invention periodically changing the growth conditions to alter the directions of the grain boundaries is useful to contribute to the formation of flat-top grains and smoothening of the surface of the $\alpha$-Al$_2$O$_3$ layer. Then, the surface of the $\alpha$-Al$_2$O$_3$ layer of the present invention is dominated by relatively large flat grains with reduced roughness.

Prior art $\alpha$-Al$_2$O$_3$ layers having a thickness of about 8 -10 $\mu$m, without top layers and without post-treatments,

show a roughness ($R_a$) from about 0.30 to 0.35 $\mu$m or higher. In contrast to that, $\alpha$-Al$_2$O$_3$ layers according to the present invention may exhibit much lower roughness (Ra) values from about 0.05 to 0.2 $\mu$m, preferably from about 0.05 to 0.15 $\mu$m or less, measured on an $\alpha$-Al$_2$O$_3$ layer without top layers and without post-treatments. Consequently, according to the invention, roughness ($R_a$) values of the coatings being at least 50-60 % lower than that of the coatings produced according to the prior art with comparable composition and the same thickness are achievable. Thinner $\alpha$-Al$_2$O$_3$ layers with a thickness from about 4 to 8 $\mu$m, when produced according to the invention, may show even lower roughness ($R_a$) values from about 0.04 to about 0.15, preferably from about 0.03 to about 0.10 $\mu$m.

If a top layer is deposited on top of a smooth $\alpha$-Al$_2$O$_3$ layer of the present invention, the roughness of the top layer is also very smooth, even though the measured roughness ($R_a$) of the top layer can be slightly higher than the roughness measured directly on the as-deposited $\alpha$-Al$_2$O$_3$ layer. However, when the top layer is deposited as a multilayer of thin sub-layers the roughness values can be nearly the same as that measured directly on the as-deposited $\alpha$-Al$_2$O$_3$ layer according to the invention.

The $\alpha$-Al$_2$O$_3$ layers of the present invention exhibit enhanced mechanical properties, such as improved flank wear resistance and edge chipping resistance being especially useful in interrupted cutting of steels and cast irons. The coatings of the present invention reduce the tendency for edge chipping, especially during the first moments when the tool is entering the work piece material. The deposition of cubic TiAlN or TiAlCN as top layer material considerably enhances the tool performance in interrupted cutting operations over the prior art. The surface finish and performance of cubic TiAlN or TiAlCN top coatings can further be improved by depositing these layers as multilayers as such or together with other cubic materials, such as TiN, or hexagonal phases, such as AlN or TiAlN, formed as a result of deposition conditions or oscillating reactions or due to self-organizing processes during the deposition or heat treatments.

A flat and smooth surface morphology of the coating of the present invention provides an attractive and technically beneficial appearance of the coating. The coatings of to the present invention exhibit a shiny high-quality tool surface with low surface roughness, which in addition to optical effects enable easier wear detection than prior art coatings.

Definitions:

The following definitions shall define terms used in the present description and claims to describe the present invention.

The term "fiber texture", or shortly referred to as "texture", as used herein and as it is generally used in connection with thin films produced by vapor deposition, distinguishes the orientation of the grown grains from random orientation. Three types of textures are usually distinguished in thin films and coatings: random texture, when grains have no preferred orientation; fiber texture, where the grains in the coating are oriented such that one set of geometrically equivalent crystallographic planes {h k l} is found to be preferentially oriented parallel to the substrate, while there is a rotational degree of freedom of the grains around the fiber axis which is perpendicular to this plane, and thus preferentially orientated perpendicular to the substrate; and epitaxial alignment (or in-plane texture) on single-crystal substrates, where an in-plane alignment fixes all three axes of the grain with respect to the substrate. It is emphasized that the coatings discussed in the earlier patent literature as well as here all exhibit a fiber texture, and the term "(h k l) texture" thus means a fiber texture with the {h k l} planes preferentially oriented parallel to the substrate surface.

The crystallographic plane of a crystal is defined by the Miller-Bravais indices, h, k, i and l, expressed in the 3-index notation omitting the index i [i = -(h+k)], i. e. crystallographic plane {h k l}. A "preferred" growth along the <h k l> crystallographic direction means that the growth along the <h k l> crystallographic direction occurs more frequently than growth along other crystallographic directions. It has to be noted that the terminology "growth along the <h k l> crystallographic direction", related to a (h k l) fiber texture with preferred orientation of {h k l} planes parallel to the substrate, is only appropriate when the <h k l> direction is perpendicular to the {h k l} planes. This is not generally valid for all crystallographic directions and planes in the trigonal-hexagonal crystal system to which $\alpha$-Al$_2$O$_3$ belongs, however, it does hold true for the corresponding pairs of <1 0 0> and {1 0 0}, <1 1 0> and {1 1 0}, and <0 0 1 > and {0 0 1} directions and planes, respectively. The <0 1 2> and {0 1 2}, and <1 0 4> and {1 0 4} directions and planes, respectively, are not perpendicular to each other. Therefore, for the definition of preferred crystallographic orientation of deposited $\alpha$-Al$_2$O$_3$ layers and for growth conditions, in the present application, there is referred to the texture, defined by the texture coefficient TC, rather than the crystallographic direction of the growth.

The texture coefficient TC is calculated using the Harris formula on the basis of a defined set of XRD reflections measured on the respective sample. The intensities of the XRD reflections are standardized using a JCPDF-card indicating the intensities of the XRD reflections of the same material, e. g. $\alpha$-Al$_2$O$_3$, but with random orientation, such as in a powder of the material. A texture coefficient TC (h k l) > 1 of a layer of crystalline material is an indication that the grains of the crystalline material are oriented with their {h k l} crystallographic plane parallel to the substrate surface more frequently than in a random distribution, at least compared to the XRD reflections used in the Harris formula to determine the texture coefficient TC.

In the present application, $\alpha$-Al$_2$O$_3$ coatings are described to have (0 0 1), (1 0 0), (1 1 0), (1 0 4) and (0 1 2) textures, respectively. This means that the $\alpha$-Al$_2$O$_3$ grains of the coatings are oriented with their {0 0 1}, {1 0 0}, {1 1 0}, {1 0 4} or {0 1 2} crystallographic planes, respectively, nearly parallel to the substrate surface more frequently than in a random distribution.

The {0 0 1} crystallographic plane is parallel to the {0 0 6} and {0 0 12} crystallographic planes in the $\alpha$-Al$_2$O$_3$ crystallographic system. The TC (0 0 1) is herein represented by TC (0 0 12). TC (0 0 12) is used instead of TC (0 0 6) since the (0 0 6) reflection from $\alpha$-Al$_2$O$_3$ is partly overlapped by a reflection from TiCN that is often applied as a layer in the coating system. TC(1 0 0) is determined using the (3 0 0) XRD reflection of $\alpha$-Al$_2$O$_3$.

By "(h k l) process conditions" or "(h k l) step" it is meant that, if such process condition were used to deposit a single $\alpha$-Al$_2$O$_3$ layer having a thickness more than about 4 $\mu$m, a coating with $\alpha$-Al$_2$O$_3$ having a texture coefficient TC(h k l) > 3 would have been obtained.

The phrase "texture plane" refers to the plane that would be parallel to the substrate according to the defined texture determined by XRD.

CVD process conditions, that are generally suitable to produce $\alpha$-Al$_2$O$_3$ layers having (0 0 1), (1 0 0), (1 1 0), (1 0 4) and (0 1 2) textures, are generally known in the art and described in the scientific and patent literature (see for example the prior art references cited above). The present specification provides further examples of suitable process conditions. In this connection it has to be noted that CVD process conditions to produce the textured coatings mentioned above may vary within a broad range. Therefore, the scope of the invention and the definition of the claimed subject-matter to solve the underlying problem shall not be limited to specific CVD process parameters and reaction gas compositions. The present invention rather has its basis in the surprising finding that improved properties of coated cutting tool inserts are achieved by the method of the present invention depositing the $\alpha$-Al$_2$O$_3$ layer by the process conditions, as defined herein, especially a change in process conditions to achieve the change in grain boundary growth. By knowing the present invention and the concept behind it, the skilled person will easily find the parameters of CVD process conditions to obtain such a specific crystal growth of the $\alpha$-Al$_2$O$_3$ layer, as defined according to the present invention. As stated above, process conditions to produce preferred growth directions or fibre textures, respectively, of $\alpha$-Al$_2$O$_3$ have been known in the art and are found in the literature. However, applying the specific sequences of process conditions, as defined herein, to obtain zigzag grain boundaries, improved surface finish, reduced surface roughness and improved mechanical properties was surprising and has never been described before

In a preferred embodiment of the coated cutting tool insert of the present invention the peak-to-peak distance, measured along the normal to the substrate surface, from one directional change to the next directional change of the same grain boundary is from 0.05 to 4 $\mu$m, preferably from 0.1 to 3 $\mu$m, more preferably from 0.2 to 2 $\mu$m, and/or the peak-to-peak distance, measured parallel to the substrate surface, from one directional change to the next directional change of the same grain boundary is from 0.05 to 4 $\mu$m, preferably from 0.1 to 3 $\mu$m, more preferably from 0.2 to 2 $\mu$m.

In another embodiment of the coated cutting tool insert of the present invention at least 70%, preferably at least 80%, more preferably at least 90%, of the $\alpha$-Al$_2$O$_3$ crystals extending to the outer surface of the $\alpha$-Al$_2$O$_3$ layer are terminated by facets perpendicular to an axis within 0 to 35 degrees, preferably within 0 to 20 degrees, more preferably within 0 to 10 degrees to the normal of the substrate surface, preferably these facets terminating the $\alpha$-Al$_2$O$_3$ crystals are {0 0 1} crystallographic planes. The orientation of the facets terminating the $\alpha$-Al$_2$O$_3$ crystals at the outer surface of the $\alpha$-Al$_2$O$_3$ layer can be determined by EBSD or by SEM microphotograph of a cross section of the layer.

In yet another preferred embodiment of the present invention the outer surface of the $\alpha$-Al$_2$O$_3$ layer in the as-deposited and unblasted state has the following surface roughness characteristics:

i) a surface roughness Ra from 0.05 to 0.2 $\mu$m, preferably from 0.05 to 0.15 $\mu$m, when the layer of $\alpha$-Al$_2$O$_3$ has a thickness of 8 $\mu$m or more;
ii) a surface roughness Ra from 0.03 to 0.2 $\mu$m, preferably from 0.03 to 0.10 $\mu$m, when the layer of $\alpha$-Al$_2$O$_3$ has a thickness of less than 8 $\mu$m,

whereby the surface roughness is measured on the $\alpha$-Al$_2$O$_3$ layer in the as-deposited state without top layers and without post-treatment.

In yet another preferred embodiment of the coated cutting tool insert of the present invention the overall fiber texture of the entire $\alpha$-Al$_2$O$_3$ layer is characterized by a texture coefficient TC (0 0 12) > 3, the TC (0 0 12) being defined as follows:

$$TC(0\,0\,12) = \frac{I(0\,0\,12)}{I_0(0\,0\,12)}\left[\frac{1}{n}\sum_{n-1}^{n}\frac{I(hkl)}{I_0(hkl)}\right]^{-1},$$

or

a texture coefficient TC (3 0 0) > 3, the TC (3 0 0) being defined as follows:

$$TC(3\,0\,0) = \frac{I(3\,0\,0)}{I_0(3\,0\,0)} \left[ \frac{1}{n} \sum_{n-1}^{n} \frac{I(hkl)}{I_0(hkl)} \right]^{-1},$$

or
a texture coefficient TC (1 1 0) > 3, the TC (1 1 0) being defined as follows:

$$TC(11\,0) = \frac{I(1\,1\,0)}{I_0(1\,1\,0)} \left[ \frac{1}{n} \sum_{n-1}^{n} \frac{I(hkl)}{I_0(hkl)} \right]^{-1},$$

or
a texture coefficient TC (1 0 4) > 3, the TC (1 0 4) being defined as follows:

$$TC(10\,4) = \frac{I(1\,0\,4)}{I_0(1\,0\,4)} \left[ \frac{1}{n} \sum_{n-1}^{n} \frac{I(hkl)}{I_0(hkl)} \right]^{-1},$$

or
a texture coefficient TC (0 1 2) > 3, the TC (0 1 2) being defined as follows:

$$TC(01\,2) = \frac{I(0\,1\,2)}{I_0(0\,1\,2)} \left[ \frac{1}{n} \sum_{n-1}^{n} \frac{I(hkl)}{I_0(hkl)} \right]^{-1},$$

wherein

I (h k l) = measured intensity of the (hkl) reflection
$I_0$ (h k l) = standard intensity of the standard powder diffraction data according to JCPDF-card no. 42-1468
n = number of reflections used in the calculation, whereby the (hkl) reflections used are: (0 1 2), (1 0 4), (1 1 0), (1 1 3), (1 1 6), (3 0 0) and (0 0 12).

The method for measuring the texture coefficient TC is described below.

In yet another preferred embodiment of the coated cutting tool insert of the present invention the coating comprises a top coating of a thickness between 0.1 to 3 $\mu$m, preferably between 0.2 to 2 $\mu$m, more preferably between 0.5 to 1.5 $\mu$m, by CVD on top of the $\alpha$-Al$_2$O$_3$ layer, the top coating consisting of layers of TiN, TiC, TiCN, ZrN, ZrCN, HfN, HfCN, VC, TiAIN, TiAICN, AIN or combinations or multilayers thereof.

Even though the alumina layer of the present invention can be the uppermost layer of the entire coating, it is preferred to, at least partly, provide a top coating on top of the $\alpha$-Al$_2$O$_3$ layer. Therefore, in yet another preferred embodiment of the present invention the coating comprises a top coating of a thickness between 0.1 to 3 $\mu$m, preferably between 0.2 to 2 $\mu$m, more preferably between 0.5 to 1.5 $\mu$m, deposited by CVD on top of the $\alpha$-Al$_2$O$_3$ layer, the top coating consisting of layers of TiN, TiC, TiCN, ZrN, ZrCN, HfN, HfCN, VC, TiAIN, TiAICN, AIN or combinations or multi-layers thereof.

The top coating layer on top the $\alpha$-Al$_2$O$_3$ layer can be provided as a wear indicator and/or as a layer of other functions. For wear detection the coating should preferably be terminated by a coloured coating material, such as TiN, TiCN or AIN. Colours, such as blue, green or violet, can also be produced by oxidisation or anodic-oxidation of the above-mentioned coatings. The techniques to produce coloured coatings by oxidation or anodic oxidation are known and described in the literature.

The present invention includes also those embodiments, where only parts of the surface areas of the cutting tool insert, preferably the rake face of the cutting tool insert, shall comprise the $\alpha$-Al$_2$O$_3$ layer as the outermost layer whereas the remaining surface areas shall be covered with the top coating as the outermost layer. These embodiments can be produced by removing the deposited top coating by way of blasting or any other well-known method from those

areas where the $\alpha$-Al$_2$O$_3$ layer shall be the outermost layer.

In yet another preferred embodiment of the present invention the coating comprises one or more refractory layers on the substrate and underneath the $\alpha$-Al$_2$O$_3$ layer, wherein the one or more refractory layers consisting of carbide, nitride, carbonitride, oxycarbonitride or borocarbonitride of one or more of Ti, Al, Zr, V and Hf, or combinations thereof, being deposited by chemical vapour deposition (CVD) or moderate temperature chemical vapour deposition (MT-CVD) and each refractory layer having a thickness of from 0.5 to 20 $\mu$m, preferably from 1 to 10 $\mu$m.

In yet another preferred embodiment of the present invention the first refractory layer immediately on top and in contact with the substrate surface consists of carbide, nitride, carbonitride, oxycarbonitride, oxynitride or borocarbonitride of one or more of Ti, Al, Zr, V, Hf or combinations or multilayers thereof, preferably Ti(C,N), TiN, TiC, Ti(B,C,N), HfN, Zr(C,N) or combinations or multi-layers thereof. More preferably the first refractory layer adjacent to the substrate surface consists of or comprises Ti(C,N). The first refractory layer is deposited by CVD or MT-CVD, and preferably the first refractory layer has a thickness of from 0.5 to 20 $\mu$m, more preferably from 1 to 10 $\mu$m. It has been found that this type of first refractory layer in combination with the inventive type of $\alpha$-Al$_2$O$_3$ layer provides a good overall wear resistance.

A particularly suitable first refractory layer comprises or consists of oxides, nitrides, carbonitrides or oxycarbonitrides of Ti and/or Al as single layers or multilayers, such as TiN, Ti(C,N), hexagonal AlN, cubic or hexagonal TiAlN, TiAlON, TiAlCN, TiAlOCN, metastable or stable Al$_2$O$_3$ phases or combinations thereof, preferably cubic Ti$_{1-x}$Al$_x$N or Ti$_{1-x}$Al$_x$C$_y$N$_z$ with x >0.7 deposited by means of low-pressure moderate temperature chemical vapour deposition (LP-MT-CVD). The cubic Ti$_{1-x}$Al$_x$N or Ti$_{1-x}$Al$_x$C$_y$N$_z$ can be co-deposited together with layers of hexagonal AlN, TiAlN or TiAlCN. The hexagonal phase layers should be very thin as compared with the cubic layers, preferably less than about 50 nm, more preferably less than 20 nm. The LP-MT-CVD layers are deposited a temperature of 600-850° C, preferably 650-750 °C and at a pressure in the range of 2 to 50 mbar, preferably less than 10 mbar.

It is also particularly preferred when the first refractory layer comprises as the lowest layer in direct contact with the substrate a layer consisting of TiN deposited using CVD or MT-CVD or LP-MT-CVD, and having a thickness of less than 5 $\mu$m, preferably from 0.3 to 3 $\mu$m, more preferably from 0.5 to 2 $\mu$m. It has been found that providing this type of lowest layer in direct contact with the substrate surface improves the adhesion of the first refractory layer, and thus, also the adhesion of the $\alpha$-Al$_2$O$_3$ layer of the present invention.

In yet another preferred embodiment of the present invention the refractory layer immediately underneath and in contact with the $\alpha$-Al$_2$O$_3$ layer consists of cubic (Ti,Al)N or cubic (Ti,Al)(C,N) or of a multilayer structure consisting of alternating cubic (Ti,Al)N or cubic (Ti,Al)(C,N) layers and one or more refractory layers consisting of carbide, nitride, carbonitride, oxycarbonitride or boroncarbonitride of one or more of Ti, Zr, V and Hf, or combinations thereof.

The substrate of the cutting tool insert of the present invention consists of cemented carbide, cermet, ceramics, steel or cubic boron nitride. However, in a preferred embodiment of the present invention the substrate consists of cemented carbide, preferably of cemented carbide consisting of 4 to 12 wt-% Co, optionally 0.3-10 wt-% cubic carbides, nitrides or carbonitrides of the metals from groups IVb, Vb and VIb of the periodic table, preferably Ti, Nb, Ta or combinations thereof, and balance WC. For steel machining applications the cemented carbide substrate preferably contains 7.0 to 9.0 wt-% of the cubic carbides, and for cast iron machining applications the cemented carbide substrate preferably contains 0.3 to 3.0 wt-% of the cubic carbides, as defined above.

In another preferred embodiment of the present invention the substrate consists of cemented carbide comprising a binder phase enriched surface zone having a thickness of 5 to 30 $\mu$m, preferably 10 to 25 $\mu$m, from the substrate surface, the binder phase enriched surface zone having a Co content that is at least 1.5 times higher than in the core of the substrate and having a content of cubic carbides that is less than 0.5 times the content of cubic carbides in the core of the substrate. The thickness of the $\alpha$-Al$_2$O$_3$ layer in this embodiment is preferably about 4 to 12 $\mu$m, most preferably 4 to 8 $\mu$m.

Preferably, the binder phase enriched surface zone of the cemented carbide body is essentially free from cubic carbides. Providing a binder phase enriched surface zone enhances toughness of the substrate and widens the application range of the coated cutting tool. Substrates having a binder enriched surface zone are particularly preferred for cutting tool inserts for metal cutting operations in steel, whereas cutting tool inserts for metal cutting operations in cast iron are preferably produced without binder phase enriched surface zone.

In a preferred embodiment of the method of the present invention the deposition process of the $\alpha$-Al$_2$O$_3$ layer comprises the steps of periodically changing the process conditions to deposit $\alpha$-Al$_2$O$_3$ between two different process conditions, the first process condition being selected from one of the process conditions useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2), and the second process condition being selected from one of the process conditions useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2), preferably the first process condition is a process conditions useful to deposit an $\alpha$-Al$_2$O$_3$ layer having a texture coefficient TC(0 0 12) > 3, and the second process condition is a process conditions useful to deposit an $\alpha$-Al$_2$O$_3$ layer having a texture coefficient TC(1 1 0) > 3.

In another preferred embodiment of the method of the present invention the deposition time for each deposition process condition is within the range of 5 min to 180 min, preferably within the range of 10 min to 60 min, and/or during the deposition process of the $\alpha$-Al$_2$O$_3$ layer the process conditions are changed from 3 to 100 times, preferably from 4 to 80 times, more preferably from 5 to 60 times.

The deposition steps according to the present invention either follow immediately after another, or they may be separated in process by purging steps using H$_2$, N$_2$ or Ar or combinations of these. The deposition conditions, the durations of deposition steps and the number of the cycles influence the wave form of the grain boundaries. The deposition times for the alternating process conditions (steps) are not necessarily equal, but can be varied to optimize the layer properties. For example, the first step is preferably longer in duration than the following steps. Also, the deposition steps under different deposition conditions can be carried out with different durations for each condition. Further, the duration of the deposition steps and cycles can be gradually shortened or lengthened throughout the deposition of the $\alpha$-Al$_2$O$_3$ layer. It is within the purview of the skilled artisan to determine which coating steps, sequences and durations will give the best properties.

According to a preferred embodiment of the method of the invention, the deposition cycles are composed of deposition steps with equal durations that are repeated throughout of the coating to produce grain boundaries of essentially regular wave forms. In another preferred embodiment the deposition steps with different durations are repeated throughout of the coating to obtain in irregular wave forms. In another preferred embodiment, the alternating process steps are shorter towards the surface of the $\alpha$-Al$_2$O$_3$ layer resulting in gradually decreasing wavelength and amplitude of the zigzag grain boundaries towards the top of the $\alpha$-Al$_2$O$_3$ layer. In yet another embodiment the deposition times for the alternating process steps are longer towards the surface of the $\alpha$-Al$_2$O$_3$ layer resulting in increasing wavelength and amplitude of the zigzag grain boundaries towards the top of the $\alpha$-Al$_2$O$_3$ layer. In yet another embodiment the $\alpha$-Al$_2$O$_3$ layer is composed of at least one prior-art $\alpha$-Al$_2$O$_3$ layer together with at least one $\alpha$-Al$_2$O$_3$ layer according to the invention.

In a preferred embodiment of the method of the present invention the process conditions in the CVD reaction chamber useful to deposit $\alpha$-Al$_2$O$_3$ having the (001) fibre texture include:

a pressure in the range between 10 and 100 mbar, preferably between 30 and 80 mbar,
a temperature in the range of 800°C to 1050°C, preferably 930°C to 1030°C,
and reactive gas concentrations in the ranges of
between 2% and 7.5%, preferably between 3% and 5% CO$_2$,
between 0.5% and 5%, preferably between 1.5% and 4% HCl,
between 0.5% and 5%, preferably between 1.8% and 4% AlCl$_3$, and
between 0.2% and 1.1 %, preferably between 0.3% and 0.6% X.

In a preferred embodiment of the method of the present invention the process conditions in the CVD reaction chamber to deposit $\alpha$-Al$_2$O$_3$ having the (100) fibre texture include:

a pressure in the range between 200 and 300 mbar, preferably about 250 mbar,
a temperature in the range of 800°C to 1050°C, preferably 930°C to 1030°C,
and reactive gas concentrations in the ranges of more than 6% CO$_2$,
between 5% and 25%, preferably between 5% and 12% HCl,
between 0.5% and 3%, preferably between 1.0% and 1.5% AlCl$_3$, and less than 0.35%, preferably less than 0.25% X.

In a preferred embodiment of the method of the present invention the process conditions in the CVD reaction chamber to deposit $\alpha$-Al$_2$O$_3$ having the (110) fibre texture include:

a pressure in the range between 150 and 200 mbar, preferably about 150 mbar,
a temperature in the range of 800°C to 1050°C, preferably 930°C to 1030°C,
and reactive gas concentrations in the ranges of more than 5% CO$_2$,
between 5% and 25%, preferably between 5% and 10% HCl,
between 0.5% and 3%, preferably between 1.0% and 1.8% AlCl$_3$, and less than 0.35%, preferably less than 0.25% X.

In a preferred embodiment of the method of the present invention the process conditions in the CVD reaction chamber to deposit $\alpha$-Al$_2$O$_3$ having the (104) fibre texture include:

a pressure in the range between 50 and 120 mbar, preferably between about 100 to 120 mbar,
a temperature in the range of 800°C to 1050°C, preferably 930°C to 1030°C,
and reactive gas concentrations in the ranges of 3-5% CO$_2$,
between 1% and 5%, preferably between 1% and 3% HCl,
between 0.5% and 3%, preferably between 1.0% and 1.8% AlCl$_3$, and

between 0.2% and 0.9%, preferably between 0.3% and 0.5% X
2-10 vol%. preferably 3-5 vol% CO.

In a preferred embodiment of the method of the present invention the process conditions in the CVD reaction chamber to deposit $\alpha$-$Al_2O_3$ having the (012) fibre texture include:

a pressure in the range between 50 and 120 mbar, preferably between about 50-80 mbar,
a temperature in the range of 800°C to 1050°C, preferably 930°C to 1030°C,
and reactive gas concentrations in the ranges of 3-5% $CO_2$,
between 1% and 5%, preferably between 2% and 3% HCl,
between 0.5% and 3%, preferably between 1.0% and 1.8% $AlCl_3$, and
less than 0.35%, preferably less than 0.25% X
2-10 vol%, preferably 3-5 vol% CO.

In yet another preferred embodiment of the method of the present invention, in process conditions to deposit the $\alpha$-$Al_2O_3$ layer the component X is a combination of $H_2S$ and $SF_6$. This combination of $H_2S$ and $SF_6$ is particularly suitable to produce a (1 1 0) or (1 0 0) texture of the $\alpha$-$Al_2O_3$ layer. The volume proportion of $SF_6$ preferably does not exceed 15% of the volume amount of $H_2S$.

In yet another preferred embodiment of the method of the present invention, the process conditions in the CVD reaction chamber to deposit the $\alpha$-$Al_2O_3$ layer comprise the addition of $N_2$, Ar, CO or combinations thereof whereby the sum of the volume proportions of $N_2$, Ar and CO does not exceed 20% of the total volume amount of $H_2$ in the reaction gas mixture. By adding $N_2$, Ar and/or CO it is possible to modify growth rate and coating thickness variations throughout the CVD reactor. It is within the purview of the person skilled in the art to adjust these additions to the reactive gas to achieve the desired profiles of growth rate.

BRIEF DESCRIPTION OF THE FIGURES

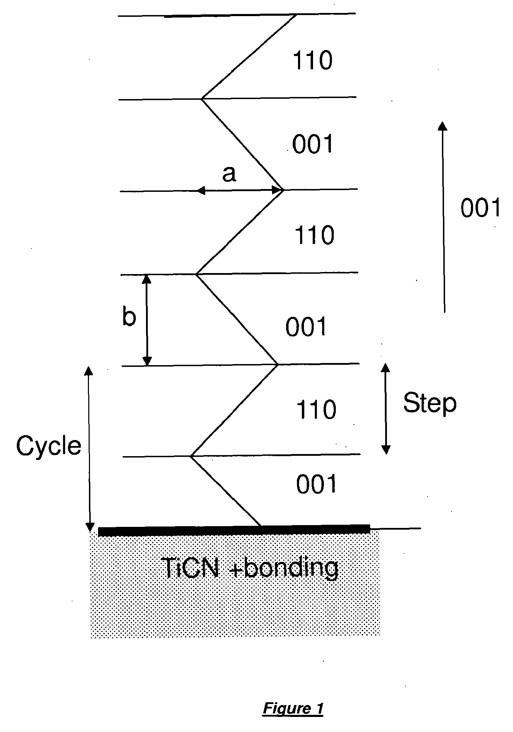

Fig. 1     shows a schematic presentation of a coating process according to the present invention including three cycles of $\alpha$-$Al_2O_3$ deposition, each cycle being composed of a (0 0 1) deposition step and a (1 1 0) deposition step with directional changes of the grain boundary growth at the transitions from one deposition step to the next deposition step, indicated by the zigzag line. The overall texture is defined by the process parameters of the first deposition step, which in this case is a (0 0 1) deposition step. The peak-to-peak distance, measured parallel to the substrate surface, from one directional change to the next directional change of the same grain boundary is indicated by the double arrow (a), and the peak-to-peak distance, measured along the normal to the substrate surface, from one directional change to the next directional change of the same grain boundary is indicated by the double arrow (b).

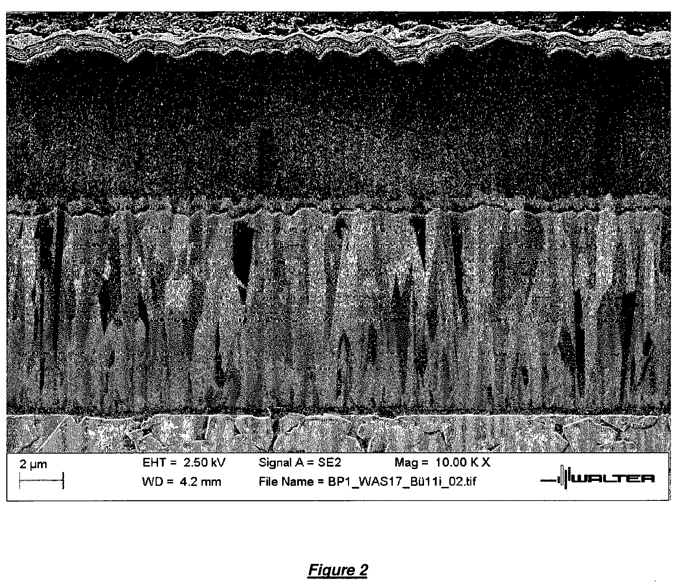

Fig. 2     shows a cross section of a SEM microphotograph of a coating with a (0 0 1) textured $\alpha$-$Al_2O_3$ layer according to the prior art. The grain boundaries of the columnar $Al_2O_3$ grains are essentially straight and do not show a tendency for the formation of zigzag boundaries in the sense of the present invention.

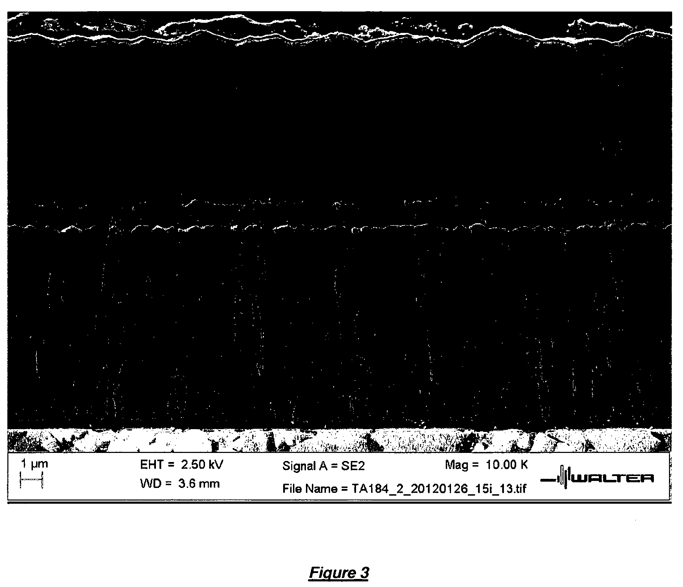

Fig. 3     shows a cross section of a SEM microphotograph of a coating with a (0 0 1) textured $\alpha$-$Al_2O_3$ layer according to the present invention. The grain boundaries of the columnar $Al_2O_3$ grains clearly show the formation of zigzag boundaries in the sense of the present invention.

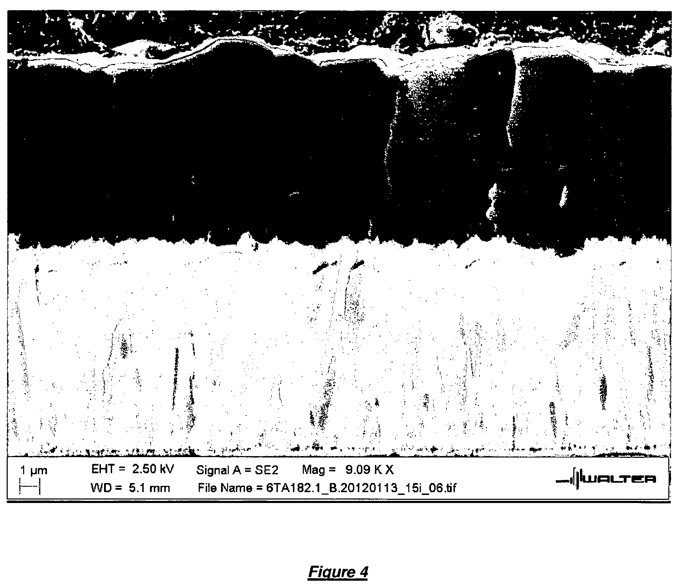

Fig. 4     shows a cross section of a SEM microphotograph of a coating with a (0 0 1) textured $\alpha$-$Al_2O_3$ layer according to the present invention, deposited by alternating (0 0 1) process conditions and (1 1 0) process conditions. The deposition was started by applying (0 0 1) process conditions for 45 min, all the subsequent steps were carried out for a duration of 30 min. The deposition was terminated by a step of (0 0 1) process conditions.

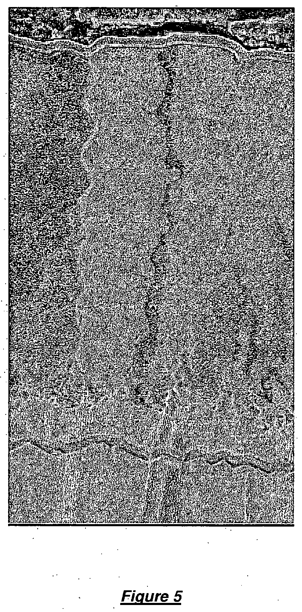

Fig. 5     shows a cross section of a SEM microphotograph of a coating with a (0 1 2) textured $\alpha$-$Al_2O_3$ layer according to the present invention. The zigzag grain boundaries are visible throughout of the layer. The directional changes can clearly be related to the change of process conditions.

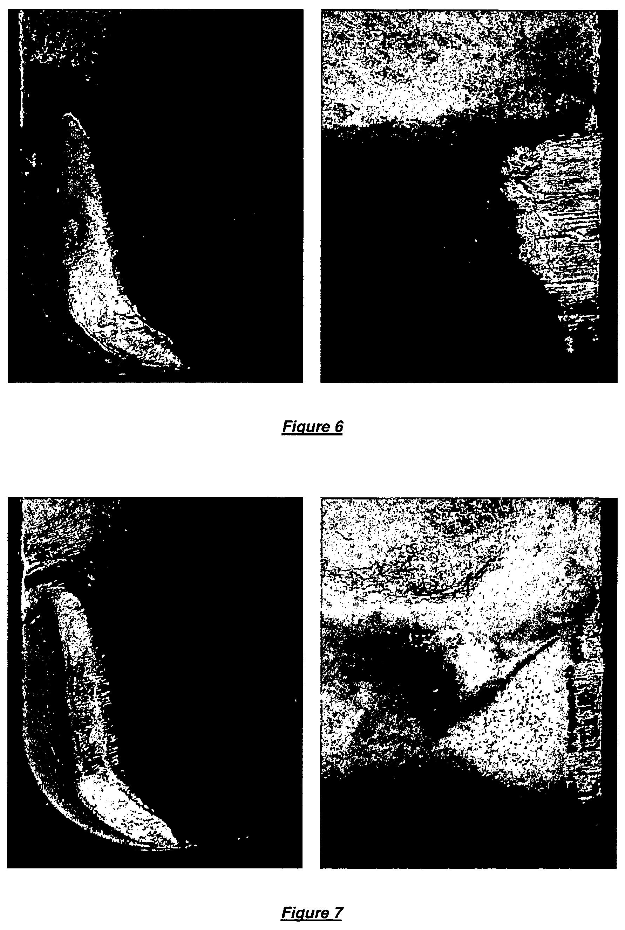

Fig. 6     shows the cutting edge of a cutting tool insert coated according to the prior art in a top view (Fig. 6, left) and in a side view (Fig. 6, right).

Fig. 7    shows the cutting edge of a cutting tool insert coated according to the present invention in a top view (Fig. 7, left) and in a side view (Fig. 7, right). A comparison of figures 6 and 7 reveals that the coating according to the present invention showed clearly less flank wear and lower crater wear than the coating according to the prior art.

METHODS

X-ray diffraction (XRD) measurements and TC determination

X-ray diffraction measurements were done on a diffraktometer XRD3003PTS of GE Sensing and Inspection Technologies using Cu $K_\alpha$-radiation. The X-ray tube was run at 40 kV and 40 mA focussed to a point. A parallel beam optic using a polycapillary collimating lens with a measuring aperture of fixed size was used on the primary side whereby the irradiated area of the sample was selected to avoid a spill over of the X-ray beam over the coated face of the sample. On the secondary side a Soller slit with a divergence of 0,4° and a 0,25 mm thick Ni $K_\beta$ filter were used. $\theta$-$2\theta$ scans within the angle range of 20° < $2\theta$ < 100° with increments of 0,25° have been conducted. The measurements were done on a flat face of the coated insert, preferably on the flank face. The measurements were done directly on the alumina layer as the outermost layer. Any layer present in the coating above the alumina layer to be measured, if any, is removed by a method that does not substantially influence the XRD measurement results, e. g. etching. For the calculation of the texture coefficient TC peak height intensities were used. Background subtraction and a parabolic peakfit with 5 measuring points were applied to the XRD raw data. No further corrections such as $K_{\alpha2}$ stripping or thin film correction were made.

Sample preparation for scanning electron microscopy (SEM)

Inserts were-cut in cross section, mounted in a holder and then treated as follows:

1. Grinding with Struers Piano220 disc with water for 6 min
2. Polishing with 9 $\mu$m MD-Largo Diamond suspension for 3 min
3. Polishing with 3 $\mu$m MD-Dac Diamond suspension for 3:40 min
4. Polishing with 1$\mu$m MD-Nap Diamond suspension for 2 min
5. Polishing/etching with OP-S colloidal silica suspension for 12 min (average grain size of the colloidal silica = 0.04 $\mu$m)

The specimens were ultrasonically cleaned before SEM examination. The directional changes of the grain boundaries of the $\alpha$-$Al_2O_3$ grains were observed and determined at a 5000 to 35000-fold magnification. To determine the number grains showing zigzag grain boundaries in an SEM microphoograph, a straight line at a distance of 1/3 of the thickness of the $\alpha$-$Al_2O_3$ layer from the top of the $\alpha$-$Al_2O_3$ layer surface and parallel to it was drawn, and the number of $\alpha$-$Al_2O_3$ grains with and without zigzag grain boundaries was counted.

CVD coatings

The CVD coatings were prepared in a radial flow reactor, type Bernex BPX 325S, having 1250 mm height and 325 mm outer diameter. Gas flow over the charging trays was radial from a central gas tube.

Roughness measurements

Roughness measurements were made according to ISO 4287, DIN 4768.

EBSD Analysis

EBSD analysis of coating 2 was performed in a Zeiss SUPRA40VP scanning electron microscope (SEM) with a field emission cathode using a 60 $\mu$m aperture and 15 kV acceleration voltage working in high current mode with a 70° incident angle of the electron beam to the polished samples surface at about 12 mm working distance. The EBSD system was EDAX (Digiview camera), and the TSL OIM Data Collection 6 and TSL OIM Analysis 6.2 software packages were used for data collection and analysis, respectively.

To determine the flatness and orientation of the facets terminating the grains of $\alpha$-$Al_2O_3$ layer which extend to the surface of the layer, coatings with $\alpha$-$Al_2O_3$ as uppermost layer, i.e. without any uppermost layer on top of $\alpha$-$Al_2O_3$ must be measured in the as-coated state, i.e. without any polishing or other surface preparation, on a planar part of the surface of the tool. Typical acquisition and processing parameters for the EBSD maps are as follows: The map size is at least 50 x 30 $\mu$m with $\leq$0.15 $\mu$m step size and a hexagonal grid of measurement points. A 4x4 binning and a background subtraction is performed on the camera picture, using exposure times corresponded to 20 to 100 frames per second. Indexing of the diffraction pattern is done by Hough transformation. The data points thus recorded should ideally be indexed with an average confidence index (CI) of > 0.2. The CI is calculated by the TSL OIM Analysis 6.2 software during automated indexing of the diffraction pattern. For a given diffraction pattern several possible orientations may be found which satisfy the diffraction bands detected by the image analysis routines. The software ranks these orientations (or solutions) using a voting scheme. The confidence index is based on the voting scheme and is given as $CI = (V_1 - V_2)/V_{IDEAL}$ where $V_1$ and $V_2$ are the number of votes for the first and second solutions and $V_{IDEAL}$ is the total possible number of votes from the detected bands. The confidence index ranges from 0 to 1. Even though there are cases when a pattern may still be correctly indexed even at a confidence index of 0, the CI can be regarded as statistical a measure for the pattern quality, which is highly dependent on the surface roughness. Samples with rough surfaces have to be polished to an extremely low roughness in order to get satisfactory pattern quality and indexing for EBSD. A CI value greater than 0.3 corresponds to 99% accuracy of the automated pattern indexing, general patterns indexed with a CI > 0.1 are considered to be correct. For correct indexing, i.e. to obtain EBSD maps with average CI greater than 0.1, prolonged polishing with abrasive / etching agents of typically 0.05 $\mu$m grain size, thus to $R_a$ values well below 0.05 $\mu$m is necessary [M. M. Nowell et al., Microscopy Today 2005, 44-48]. Hence, if a considerable fraction of the points recorded on the as-deposited, noun-polished surface of the $\alpha$-Al$_2$O$_3$ layer are indexed with a CI > 0.1, it can be concluded that these fractions of the surface being indexed with CI > 0.1 consist of grains within the $\alpha$-Al$_2$O$_3$ which are terminated by very smooth facets, being only slightly tilted, i.e. approximately by less than 35°, with respect to the sample surface, and that the neighboring grains protrude by less than approximately 0.05 $\mu$m, since otherwise the electron diffraction pattern would be disturbed by shadowing of the electron beam and hence not have been properly indexed. In the coatings according to the present invention having a smooth surface with $R_a$ < 0.2 $\mu$m, more than 50%, preferably more than 70% of all data points were indexed with a confidence index CI > 0.1, whereas for conventional coatings with $R_a$ > 0.3 $\mu$m the fraction of data points indexed with CI > 0.1 is always much lower than 50%.

EXAMPLES

The substrates for the test insert used in the examples herein were cemented carbide cutting tool inserts consisting of 6.0 wt% Co and balance WC with a binder phase enriched surface zone. The Vickers hardness of the substrates was measured to be about 1600 HV.

Pre-coating:

The substrates for the deposition of the $\alpha$-Al$_2$O$_3$ coating according the examples herein were pre-coated by the following procedures.

To ensure good adhesion of the coatings to the substrate, in all coating procedures the process was started by applying a 0.3 $\mu$m thick TiN layer onto the substrate surface by CVD at a temperature of 850°C and a pressure of 150 mbar. The reaction gas composition was 2.0 vol-% TiCl$_4$, 43 vol-% N$_2$, and balance H$_2$ at a temperature of 880 °C.

TiN pre-coated inserts were coated with a 5 $\mu$m thick Ti(C,N) layer by MT-CVD using a reaction gas composition of 0.6 vol-% CH$_3$CN, 3.8 vol-% TiCl$_4$, 20 vol-% N$_2$ and balance H$_2$ at a temperature of 880°C.

After the MT-CVD process was complete, the temperature was raised to 1000°C, and at this temperature another N-rich TiCN layer was CVD deposited for 20 min using a reaction gas composition of 2.5 vol-% TiCl$_4$, 3.5 vol-% CH$_4$, 30 vol-% N$_2$ and balance H$_2$ at a pressure of 500 mbar onto the MT-CVD layer to a thickness of approximately 0.3 $\mu$m.

Then, an about 0.5 - 1 $\mu$m, thick (Ti,Al)(C,N,O) bonding layer was deposited on top of the MT-CVD TiCN layer using a reaction gas composition of 3 vol-% TiCl$_4$, 0.5 vol-% AlCl$_3$, 4.5 vol-% CO, 30 vol-% N$_2$ and balance H$_2$ for about 30 min at a temperature of about 1000°C and a pressure of 80 mbar. The deposition process was followed by a purge using H$_2$ for 10 min before starting the next step.

Before the deposition of the $\alpha$-Al$_2$O$_3$ layer, a nucleation (oxidation) step was carried out by treating the (Ti,Al)(C,N,O) bonding layer with a gas mixture of 4 vol-% CO$_2$, 9 vol-% CO, 25 vol-% N$_2$ and balance H$_2$ for 2 - 10 min at a temperature of about 1000 to 1020°C and at a pressure of about 80 to 100 mbar. The nucleation step was followed by a purge using Ar for 10 min.

Example 1: Alumina layers according to prior art (comparative examples)

The alumina deposition on the pre-coated substrates, as described above, was started by introducing the reaction gas components in the amounts as indicated in the following Table 1 and at the also indicated temperatures and pressures. The type of (h k l) process conditions also indicated. The reaction gas components were introduced simultaneously, except for HCl and H$_2$S or SF$_6$, respectively. After 2 min, HCl was added to the reaction gas mixture flowing into the reactor. After another 8 min $H_2S$ or $SF_6$ was added to the reaction gas mixture flowing into the reactor.

The deposition conditions were maintained for about 8 hours to obtain about 8 $\mu$m thick $\alpha$-$Al_2O_3$ layers. In the visual inspection the $\alpha$-$Al_2O_3$ layers appeared dark and dull. The coatings were analysed by roughness measurements, cutting tests, optical microscopy, SEM and XRD.

Table 1

| Coating No. | Condition | $CO_2$ | $AlCl_3$ | $H_2S$ | $SF_6$ | HCl | CO | $H_2$ | T ($^{\circ}$C) | P (mbar) |
|---|---|---|---|---|---|---|---|---|---|---|
| 1 | (1 0 0) | 6.5 | 1.2 | 0.05 | --- | 9.8 | --- | bal | 1000 | 250 |
| 2 | (1 1 0) | 5.6. | 1.5 | 0.10 | --- | 7.1 | --- | bal | 1000 | 150 |
| 3 | (012) | 4.9 | 1.6 | 0.22 | --- | 3.1 | 2.5 | bal | 990 | 75 |
| 4 | (0 0 1) | 4.0 | 2.4 | 0.32 | --- | 1.4 | 0 | bal | 1010 | 65 |
| 5 | (0 0 1) | 4.0 | 2.0 | --- | 0.9 | 2.4 | 0 | bal | 1000 | 50 |

On the basis of the XRD data the texture coefficients TC(h k l) of coatings nos. 1 - 5 were determined, and the texture coefficients are given in Table 2. The coatings had very clear overall textures, and the grains of all of these the coatings according to the prior art exhibited straight grain boundaries, practically no zigzag boundaries could be found. Even though it is possible to find grain boundaries exhibiting some kind of wave-like character in the textured prior art coatings, this is, however, not considered as zigzag boundaries and cannot be related to process parameters.

Table 2

| Coating No. | TC |
|---|---|
| 1 | TC(100) = 6.2 |
| 2 | TC(110) = 6.6 |
| 3 | TC(012) = 5.7 |
| 4 | TC(001) = 6.1 |
| 5 | TC(001) = 6.9 |

Example 2: Alumina layers according to the present invention (Coating 2)

The alumina deposition according to the present invention on the pre-coated substrates was carried out by applying a starting step (step 1) under first process conditions as described for the initiation of the depositions in example 1, i.e. in the first process step the reaction gas components were introduced simultaneously, except for HCl and $H_2S$, after 2 min, HCl was added to the reaction gas mixture flowing into the reactor, and after another 8 min $H_2S$ was added to the reaction gas mixture flowing into the reactor. The deposition time under the starting step conditions was 45 min.

Then, the process conditions were then periodically changed between the process conditions step 1 and step 2, as indicated in table 3. A cycle consists of 2 depositions steps. Table 3 indicates the number of cycles, the step times and the terminating step to deposit the $\alpha$-$Al_2O_3$ layers. As mentioned above, the indicated step times do apply for the deposition steps subsequent to the starting step, whereas the starting step was for 45 min.

The coatings were analysed by roughness measurements, cutting tests, optical microscopy, SEM and XRD. Table 4 indicates the texture coefficients and the number ($I_{zz}$) of observed grains with zigzag grain boundaries out of 25 $\alpha$-$Al_2O_3$ grains, according to the definition of the present invention. It was clearly confirmed that the textures of the coatings was determined by the deposition conditions of the starting step.

Table 3

| Coating No. | Step 1 | Step 2 | No. of Cycles | Terminating step | Time Step 1 [min] | Time Step 2 [min] |
|---|---|---|---|---|---|---|
| 6 | (0 0 1) | (1 1 0) | 6.5 | (0 0 1) | 30 | 30 |
| 7 | (0 1 2) | (0 0 1) | 6 | (0 0 1) | 30 | 30 |
| 8 | (0 0 1) | (0 1 2) | 9 | (0 1 2) | 5 | 20 |
| 9 | (0 0 1) | (0 1 2) | 4 | (0 1 2) | 75 | 45 |

(continued)

| Coating No. | Step 1 | Step 2 | No. of Cycles | Terminating step | Time Step 1 [min] | Time Step 2 [min] |
|---|---|---|---|---|---|---|
| 10 | (0 1 2) | (1 1 0) | 4 | (1 1 0) | 5 | 20 |
| 11 | (0 0 1) | (1 1 0) | 6.5 | (0 0 1) | 30 | 30 |
| 12 | (1 1 0) | (0 1 2) | 6 | (0 1 2) | 30 | 30 |
| 13 | (1 0 0) | (0 0 1) | 6 | (0 0 1) | 30 | 30 |
| 14 | (0 0 1) | (1 1 0) | 6.5 | (0 0 1) | 30 | 30 |

Table 4

| Coating No. | TC | $I_{zz}$ |
|---|---|---|
| 6 | TC(001) = 6.4 | 14 |
| 7 | TC(012) = 5.7 | 9 |
| 8 | TC(001) = 6.6 | 16 |
| 9 | TC(001) = 6.5 | 8 |
| 10 | TC(012) = 5.9 | 9 |
| 11 | TC(001) = 4.5 | 23 |
| 12 | TC(110) = 4.0 | 18 |
| 13 | TC(100) = 4.0 | 8 |
| 14 | TC(001) = 6.2 | 25 |

Example 3:

Cross-section SEM microphotographs of the $\alpha$-Al$_2$O$_3$ coatings of examples 1 and 2 were taken.

Figure 2 shows the cross-sectional images of coating no. 4 (prior art), figure 3 shows the cross-sectional images of coating no. 6 (invention), and figure 4 shows the cross-sectional images of coating no. 14 (invention).

The grain boundaries between the columnar grains in coating 4 are straight and no tendency for the formation of the zigzag boundaries can be seen. Coatings 6 and 14 clearly show zigzag grain boundaries at 14 (coating 6) and 25 (coating 14) of 25 $\alpha$-Al$_2$O$_3$ grains. As seen in figure 4 of coating 14, it is quite seldom that the entire zigzag boundaries are visible throughout the whole coating layer. The reason is that the $\alpha$-Al$_2$O$_3$ grains are tilted and rotated (fiber texture) with respect to the 2-diamensional cross-section and often only a part of a grain boundary can be intersected and revealed. Further physical constrains during competing grain growth will contribute to the fact that not all of the grains are free to complete zigzag growth.

Example 4: Metal Cutting Tests 1

The cutting tool inserts with coatings 2, 3 and 4 according to the prior art and 6, 8 and 9 according to the invention were tested with respect to edge chipping (flaking) on the contact area in longitudinal turning in cast iron without coolant under the following conditions:

Work piece:     Cylindrical bar
Material:       SS0130
Insert type:    SNUN120412
Cutting speed:  400 m/min
Feed:           0.4 mm/rev
Depth of cut:   2.0 mm

The inserts were inspected after a cutting time of 2 minutes and 6 minute, respectively, and the results are shown in table 5.

Table 5

| Coating No. | Flaking after 2 min [%] | Flaking after 6 min [%] |
|---|---|---|
| 2 (prior art) | 8 | 22 |
| 3 (prior art) | 8 | 18 |
| 4 (prior art) | 4 | 12 |
| 6 (invention) | 0 | 6 |
| 8 (invention) | 0 | 6 |
| 9 (invention) | 0 | 3 |

Example 5: Metal Cutting Tests 2

The cutting tool inserts with coatings 4 according to the prior art and 9 according to the invention were tested with respect to flank wear and crater wear in longitudinal turning of steel C45 without coolant (dry turning) under the following conditions:

| | |
|---|---|
| Work piece: | Cylindrical bar |
| Material: | C45 |
| Insert type: | CNMA 120412 |
| Cutting speed: | 240 m/min |
| Feed: | 0.32 mm/rev |
| Depth of cut: | 2.5 mm |

The tool lives were 22 min for coating 4 according to the prior art and 27 min for coating 9 according to the invention. Figure 6 shows the cutting edge of the insert with coating 4 according to the prior art and figure 7 shows the cutting edge of the insert with coating 9 according to the invention. As clear from the figures 6 and 7, the layer according to the invention showed clearly less flank wear and somewhat lower crater wear than the prior art layer.

Example 6: Roughness Measurements

Roughness ($R_a$) measurements were performed on coatings 4, 6 and 11. The results of an average of 5 measurements on each sample are shown in table 6.

Table 6

| Coating No. | $R_a$ [$\mu$m] |
|---|---|
| 4 (prior art) | 0.35 |
| 6 (invention) | 0.12 |
| 11 (invention) | 0.05 |

Example 7

In order to study the texture of the coatings obtained according to the invention in more detail, inverse pole figures were measured on coatings 4 (prior art), 6 (invention) and 8 (invention).
The pole figures revealed that in the coatings according the present invention, even though the growth conditions had periodically been altered in coatings 6 and 8, no additional texture components were present in the coatings.

**Claims**

1. A coated cutting tool insert consisting of a substrate of cemented carbide, cermet, ceramics, steel or cubic boron nitride having deposited thereon a coating of a total thickness of a maximum of 60 $\mu$m consisting of one or more refractory layers comprising an outer wear resistant layer of $\alpha$-Al$_2$O$_3$ of a thickness of 2 to 45 $\mu$m deposited by chemical vapour deposition (CVD),
**characterized in that**
when observed in a SEM microphotograph of a cross section of the $\alpha$-Al$_2$O$_3$ layer,
the $\alpha$-Al$_2$O$_3$ layer has an essentially columnar $\alpha$-Al$_2$O$_3$ grain structure, and
the grain boundaries of at least 1 out of 25 $\alpha$-Al$_2$O$_3$ grains, preferably at least 5 out of 25 $\alpha$-Al$_2$O$_3$ grains, more preferably at least 15 out of 25 $\alpha$-Al$_2$O$_3$ grains, along the length of the grain boundaries, undergo at least 3, preferably at least 4, more preferably at least 5, directional changes, wherein each directional change of two neighbouring sections of the same grain boundary is at an angle of from 15 to 165 degrees, preferably from 30 to 150 degrees, more preferably from 45 to 135 degrees.

2. The coated cutting tool insert of claim 1, wherein the peak-to-peak distance, measured along the normal to the substrate surface, from one directional change to the next directional change of the same grain boundary is from 0.05 to 4 $\mu$m, preferably from 0.1 to 3 $\mu$m, more preferably from 0.2 to 2 $\mu$m, and/or
the peak-to-peak distance, measured parallel to the substrate surface, from one directional change to the next directional change of the same grain boundary is from 0.05 to 4 $\mu$m, preferably from 0.1 to 3 $\mu$m, more preferably from 0.2 to 2 $\mu$m.

3. The coated cutting tool insert of any of the foregoing claims, wherein at least 70%, preferably at least 80%, more preferably at least 90%, of the $\alpha$-Al$_2$O$_3$ crystals extending to the outer surface of the $\alpha$-Al$_2$O$_3$ layer are terminated by facets perpendicular to an axis within 0 to 35 degrees, preferably within 0 to 20 degrees, more preferably within 0 to 10 degrees to the normal of the substrate surface, preferably these facets terminating the $\alpha$-Al$_2$O$_3$ crystals are {0 0 1} crystallographic planes.

4. The coated cutting tool insert of any of the foregoing claims, wherein the outer surface of the $\alpha$-Al$_2$O$_3$ layer in the as-deposited and unblasted state has the following surface roughness characteristics:

   i) a surface roughness Ra from 0.05 to 0.2 $\mu$m, preferably from 0.05 to 0.15 $\mu$m, when the layer of $\alpha$-Al$_2$O$_3$ has a thickness of 8 $\mu$m or more;
   ii) a surface roughness Ra from 0.03 to 0.2 $\mu$m, preferably from 0.03 to 0.10 $\mu$m, when the layer of $\alpha$-Al$_2$O$_3$ has a thickness of less than 8 $\mu$m,

   whereby the surface roughness is measured on the $\alpha$-Al$_2$O$_3$ layer in the as-deposited state without top layers and without post-treatment.

5. The coated cutting tool insert of any of the foregoing claims, wherein the overall fiber texture of the entire $\alpha$-Al$_2$O$_3$ layer is **characterized by**
a texture coefficient TC (0 0 12) > 3, the TC (0 0 12) being defined as follows:

$$TC(0\,0\,12) = \frac{I(0\,0\,12)}{I_0(0\,0\,12)}\left[\frac{1}{n}\sum_{n-1}^{n}\frac{I(hkl)}{I_0(hkl)}\right]^{-1},$$

or
a texture coefficient TC (3 0 0) > 3, the TC (3 0 0) being defined as follows:

$$TC(3\,0\,0) = \frac{I(3\,0\,0)}{I_0(3\,0\,0)}\left[\frac{1}{n}\sum_{n-1}^{n}\frac{I(hkl)}{I_0(hkl)}\right]^{-1},$$

or
a texture coefficient TC (1 1 0) > 3, the TC (1 1 0) being defined as follows:

$$TC(1\,1\,0) = \frac{I(1\,1\,0)}{I_0(1\,1\,0)} \left[ \frac{1}{n} \sum_{n-1}^{n} \frac{I(hkl)}{I_0(hkl)} \right]^{-1},$$

or
a texture coefficient TC (1 0 4) > 3, the TC (1 0 4) being defined as follows:

$$TC(1\,0\,4) = \frac{I(1\,0\,4)}{I_0(1\,0\,4)} \left[ \frac{1}{n} \sum_{n-1}^{n} \frac{I(hkl)}{I_0(hkl)} \right]^{-1},$$

or
a texture coefficient TC (0 1 2) > 3, the TC (0 1 2) being defined as follows:

$$TC(0\,1\,2) = \frac{I(0\,1\,2)}{I_0(0\,1\,2)} \left[ \frac{1}{n} \sum_{n-1}^{n} \frac{I(hkl)}{I_0(hkl)} \right]^{-1},$$

wherein

I (h k l) = measured intensity of the (hkl) reflection
$I_0$ (h k l) = standard intensity of the standard powder diffraction data according to JCPDF-card no. 42-1468
n = number of reflections used in the calculation, whereby the (hkl) reflections used are: (0 1 2), (1 0 4), (1 1 0), (1 1 3), (1 1 6), (3 0 0) and (0 0 12).

6. The coated cutting tool insert of any of the foregoing claims, wherein the coating comprises a top coating of a thickness between 0.1 to 3 $\mu$m, preferably between 0.2 to 2 $\mu$m, more preferably between 0.5 to 1.5 $\mu$m, by CVD on top of the $\alpha$-Al$_2$O$_3$ layer, the top coating consisting of layers of TiN, TiC, TiCN, ZrN, ZrCN, HfN, HfCN, VC, TiAlN, TiAlCN, AlN or combinations or multilayers thereof.

7. The coated cutting tool insert of any of the foregoing claims, wherein the coating comprises one or more refractory layers on the substrate and underneath the $\alpha$-Al$_2$O$_3$ layer, wherein the one or more refractory layers consisting of carbide, nitride, carbonitride, oxycarbonitride or borocarbonitride of one or more of Ti, Al, Zr, V and Hf, or combinations thereof, being deposited by chemical vapour deposition (CVD) or moderate temperature chemical vapour deposition (MT-CVD) and each refractory layer having a thickness of from 0.5 to 20 $\mu$m, preferably from 1 to 10 $\mu$m.

8. The coated cutting tool insert of any of the foregoing claims, wherein the first refractory layer immediately on top and in contact with the substrate surface consists of Ti(C,N), TiN, TiC, Ti(B,C,N), HfN, Zr(C,N) or combinations thereof, preferably the first refractory layer adjacent to the substrate surface consists of Ti(C,N).

9. The coated cutting tool insert of any of the foregoing claims, wherein the refractory layer immediately underneath and in contact with the $\alpha$-Al$_2$O$_3$ layer consists of cubic (Ti,Al)N or cubic (Ti,Al)(C,N) or of a multilayer structure consisting of alternating cubic (Ti,Al)N or cubic (Ti,Al)(C,N) layers and one or more refractory layers consisting of carbide, nitride, carbonitride, oxycarbonitride or boroncarbonitride of one or more of Ti, Zr, V and Hf, or combinations thereof.

10. The coated cutting tool insert of any of the foregoing claims, wherein the substrate consists of cemented carbide, preferably of cemented carbide consisting of 4 to 12 wt-% Co, optionally 0.3-10 wt-% cubic carbides, nitrides or carbonitrides of the metals from groups IVb, Vb and VIb of the periodic table, preferably Ti, Nb, Ta or combinations thereof, and balance WC.

11. The coated cutting tool insert of any of the foregoing claims, wherein the substrate consists of cemented carbide comprising a binder phase enriched surface zone having a thickness of 5 to 30 $\mu$m, preferably 10 to 25 $\mu$m, from the substrate surface, the binder phase enriched surface zone having a Co content that is at least 1.5 times higher than in the core of the substrate and having a content of cubic carbides that is less than 0.5 times the content of cubic carbides in the core of the substrate.

12. A method of manufacturing a coated cutting tool insert, preferably according to any of the foregoing claims, comprising the steps of coating a substrate of cemented carbide, cermet, ceramics, steel or cubic boron nitride with a coating of a total thickness of a maximum of 60 $\mu$m consisting of one or more refractory layers comprising an outer wear resistant layer of $\alpha$-Al$_2$O$_3$ of a thickness of 2 to 45 $\mu$m deposited by chemical vapour deposition (CVD) from a reaction gas mixture comprising H$_2$, CO$_2$, AlCl$_3$, HCl and X, with X being selected from H$_2$S, SF$_6$, SO$_2$ and combinations thereof, and the reaction gas mixture further optionally comprising additions of N$_2$, Ar, CO or combinations thereof,

**characterized in that**

the deposition process of the $\alpha$-Al$_2$O$_3$ layer comprises the steps of periodically changing the process conditions to deposit $\alpha$-Al$_2$O$_3$ at least 3 times, the process conditions being selected from those that, when applied to deposit a single $\alpha$-Al$_2$O$_3$ layer of a thickness of at least 4 $\mu$m, are useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2) and defined as follows:

$$TC(h\,k\,l) = \frac{I(h\,k\,l)}{I_0(h\,k\,l)}\left[\frac{1}{n}\sum_{n=1}^{n}\frac{I(hkl)}{I_0(hkl)}\right]^{-1}$$

wherein

I (h k l) = measured intensity of the (hkl) reflection
I$_0$ (h k l) = standard intensity of the standard powder diffraction data according to JCPDF-card no. 42-1468
n = number of reflections used in the calculation, whereby the (hkl) reflections used are: (0 1 2), (1 0 4), (1 1 0), (1 1 3), (1 1 6), (3 0 0) and (0 0 12),

wherein a change from one process condition to another process condition results in a directional change of the growth direction of $\alpha$-Al$_2$O$_3$ grain boundaries, wherein each directional change of two neighbouring sections of the same grain boundary is at an angle of from 15 to 165 degrees, preferably from 30 to 150 degrees, more preferably from 45 to 135 degrees, observable in a SEM microphotograph of a cross section of the $\alpha$-Al$_2$O$_3$ layer for at least 1 out of 25 $\alpha$-Al$_2$O$_3$ grains, preferably at least 5 out of 25 $\alpha$-Al$_2$O$_3$ grains, more preferably at least 15 out of 25 $\alpha$-Al$_2$O$_3$ grains.

13. The method of claim 12 wherein the deposition process of the $\alpha$-Al$_2$O$_3$ layer comprises the steps of periodically changing the process conditions to deposit $\alpha$-Al$_2$O$_3$ between two different process conditions, the first process condition being selected from one of the process conditions useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2), and the second process condition being selected from one of the process conditions useful to deposit an $\alpha$-Al$_2$O$_3$ layer having a texture coefficient TC(h k l) > 3, the texture coefficient being selected from TC(0 0 12), TC(1 0 0), TC(1 1 0), TC(1 0 4) and TC(0 1 2), preferably the first process condition is a process conditions useful to deposit an $\alpha$-Al$_2$O$_3$ layer having a texture coefficient TC(0 0 12) > 3, and the second process condition is a process conditions useful to deposit an $\alpha$-Al$_2$O$_3$ layer having a texture coefficient TC(1 1 0) > 3.

14. The method of any of claims 12 to 13 wherein the deposition time for each deposition process condition is within the range of 5 min to 180 min, preferably within the range of 10 min to 60 min, and/or during the deposition process of the $\alpha$-Al$_2$O$_3$ layer the process conditions are changed from 3 to 100 times, preferably from 4 to 80 times, more preferably from 5 to 60 times.

**Patentansprüche**

1. Beschichteter Schneidwerkzeugeinsatz bestehend aus einem Substrat aus Hartmetall, Cermet, Keramik, Stahl oder kubischem Bornitrid mit einer darauf abgeschiedenen Beschichtung mit einer Gesamtdicke von maximal 60 $\mu$m, welche aus einer oder mehreren feuerfesten Schichten besteht und eine äußere verschleißfeste Schicht aus $\alpha$-Al$_2$O$_3$ mit einer Dicke von 2 bis 45 $\mu$m, welche durch chemische Dampfphasenabscheidung (CVD) abgeschieden ist, umfast,

**dadurch gekennzeichnet, dass**
wenn ein Querschnitt der $\alpha$-Al$_2$O$_3$-Schicht in einer SEM-Mikrophotographie betrachtet wird,
die $\alpha$-Al$_2$O$_3$-Schicht eine im Wesentlichen säulenförmige $\alpha$-Al$_2$O$_3$-Kornstruktur aufweist, und
die Korngrenzen von mindestens 1 von 25 $\alpha$-Al$_2$O$_3$-Körnern, vorzugsweise von mindestens 5 von 25 $\alpha$-Al$_2$O$_3$-Körnern, besonders bevorzugt mindestens 15 von 25 $\alpha$-Al$_2$O$_3$-Körnern, entlang der Länge der Korngrenzen mindestens 3, vorzugsweise mindestens 4, besonders bevorzugt mindestens 5 Richtungsänderungen erfahren, wobei jede Richtungsänderung von zwei benachbarten Abschnitten derselben Korngrenze in einem Winkel von 15 bis 165 Grad, vorzugsweise von 30 bis 150 Grad, besonders bevorzugt von 45 bis 135 Grad stattfindet.

2.  Beschichteter Schneidwerkzeugeinsatz nach Anspruch 1, wobei der Peak-zu-Peak-Abstand, gemessen entlang der Normalen zu der Substratoberfläche, von einer Richtungsänderung bis zu der nächsten Richtungsänderung derselben Korngrenze von 0,05 bis 4 $\mu$m, vorzugsweise von 0,1 bis 3 $\mu$m, mehr bevorzugt von 0,2 bis 2 $\mu$m beträgt, und/oder
    der Peak-zu-Peak-Abstand, gemessen parallel zu der Substratoberfläche, von einer Richtungsänderung zu der nächsten Richtungsänderung derselben Korngrenze von 0,05 bis 4 $\mu$m, vorzugsweise von 0,1 bis 3 $\mu$m, mehr bevorzugt von 0,2 bis 2 $\mu$m beträgt.

3.  Beschichteter Schneidwerkzeugeinsatz nach einem der vorstehenden Ansprüche, wobei mindestens 70%, vorzugsweise mindestens 80%, mehr bevorzugt mindestens 90% der $\alpha$-Al$_2$O$_3$-Kristalle, welche sich bis zur äußeren Oberfläche der $\alpha$-Al$_2$O$_3$-Schicht erstrecken, durch Fassetten senkrecht zu einer Achse innerhalb von 0 bis 35 Grad, vorzugsweise innerhalb von 0 bis 20 Grad, mehr bevorzugt innerhalb von 0 bis 10 Grad auf die Normale der Substratoberfläche abgeschlossen werden, wobei vorzugsweise diese Fassetten, welche die $\alpha$-Al$_2$O$_3$-Kristalle abschließen, kristallographische {0 0 1} Ebenen sind.

4.  Beschichteter Schneidwerkzeugeinsatz nach einem der vorstehenden Ansprüche, wobei die äußere Oberfläche der $\alpha$-Al$_2$O$_3$-Schicht in dem Zustand wie abgeschieden und nicht gestrahlt die folgenden Oberflächenrauheitseigenschaften aufweist:

    i) eine Oberflächenrauheit Ra von 0,05 bis 0,2 $\mu$m, vorzugsweise von 0,05 bis 0,15 $\mu$m, wenn die Schicht aus $\alpha$-Al$_2$O$_3$ eine Dicke von 8 $\mu$m oder mehr aufweist,
    ii) eine Oberflächenrauheit Ra von 0,03 bis 0,2 $\mu$m, vorzugsweise von 0,03 bis 0,10 $\mu$m, wenn die Schicht aus $\alpha$-Al$_2$O$_3$ eine Dicke von weniger als 8 $\mu$m aufweist, wobei die Oberflächenrauheit auf der $\alpha$-Al$_2$O$_3$-Schicht in dem Zustand wie abgeschieden ohne Deckschichten und ohne Vorbehandlung gemessen wird.

5.  Beschichteter Schneidwerkzeugeinsatz nach einem der vorstehenden Ansprüche, wobei die gesamte Fasertextur der gesamten $\alpha$-Al$_2$O$_3$-Schicht **gekennzeichnet ist durch**
    einen Texturkoeffizienten TC (0 0 12) > 3, wobei der TC (0 0 12) wie folgt definiert ist:

$$TC(0\,0\,12) = \frac{I(0\,0\,12)}{I_0(0\,0\,12)} \left[ \frac{1}{n} \sum_{n-1}^{n} \frac{I(hkl)}{I_0(hkl)} \right]^{-1},$$

oder
einen Texturkoeffizienten TC (3 0 0) > 3, wobei der TC (3 0 0) wie folgt definiert ist:

$$TC(3\,0\,0) = \frac{I(3\,0\,0)}{I_0(3\,0\,0)} \left[ \frac{1}{n} \sum_{n-1}^{n} \frac{I(hkl)}{I_0(hkl)} \right]^{-1},$$

oder
einen Texturkoeffizienten TC (1 1 0) > 3, wobei der TC (1 1 0) wie folgt definiert ist:

$$TC(1\,1\,0) = \frac{I(1\,1\,0)}{I_0(1\,1\,0)} \left[ \frac{1}{n} \sum_{n-1}^{n} \frac{I(hkl)}{I_0(hkl)} \right]^{-1},$$

oder
einen Texturkoeffizienten TC (1 0 4) > 3, wobei der TC (1 0 4) wie folgt definiert ist:

$$TC(1\,0\,4) = \frac{I(1\,0\,4)}{I_0(1\,0\,4)}\left[\frac{1}{n}\sum_{n-1}^{n}\frac{I(hkl)}{I_0(hkl)}\right]^{-1},$$

oder
einen Texturkoeffizienten TC (0 1 2) > 3, wobei der TC (0 1 2) wie folgt definiert ist:

$$TC(0\,1\,2) = \frac{I(0\,1\,2)}{I_0(0\,1\,2)}\left[\frac{1}{n}\sum_{n-1}^{n}\frac{I(hkl)}{I_0(hkl)}\right]^{-1},$$

wobei

I (h k l) = gemessene Intensität der (hkl)Reflexion
$I_0$ (h k l) = Standardintensität der Standardpulverdiffraktionsdaten gemäß JCPDF-Karte Nr. 42-1468
n = Anzahl der in der Berechnung benutzten Reflexionen, wobei die benutzten (hkl)-Reflexionen (0 1 2), (1 0 4), (1 1 0), (1 1 3), (1 1 6), (3 0 0) und (0 0 12) sind.

6. Beschichteter Schneidwerkzeugeinsatz nach einem der vorstehenden Ansprüche, wobei die Beschichtung eine durch CVD auf der $\alpha$-Al$_2$O$_3$-Schicht hergestellte Deckschicht mit einer Dicke zwischen 0,1 bis 3 $\mu$m, vorzugsweise zwischen 0,2 bis 2 $\mu$m, besonders bevorzugt zwischen 0,5 bis 1,5 $\mu$m, aufweist, wobei die Deckschicht aus Schichten aus TiN, TiC, TiCN, ZrN, ZrCN, HfN, HfCN, VC, TiAlN, TiAlCN, AlN oder Kombinationen oder Mehrlagenschichten davon besteht.

7. Beschichteter Schneidwerkzeugeinsatz nach einem der vorstehenden Ansprüche, wobei die Beschichtung eine oder mehrere feuerfeste Schichten auf dem Substrat und unterhalb der $\alpha$-Al$_2$O$_3$-Schicht aufweist, wobei die eine oder mehrere feuerfeste Schicht(en) aus Carbid, Nitrid, Carbonitrid, Oxycarbonitrid oder Borcarbonitrid von einem oder mehreren von Ti, Al, Zr, V und Hf oder Kombinationen davon besteht, abgeschieden durch chemische Dampfphasenabscheidung (CVD) oder chemische Dampfphasenabscheidung bei mittlerer Temperatur (MT-CVD) abgeschieden sind und wobei jede feuerfeste Schicht eine Dicke von 0,5 bis 20 $\mu$m, vorzugsweise von 1 bis 10 $\mu$m, hat.

8. Beschichteter Schneidwerkzeugeinsatz nach einem der vorstehenden Ansprüche, wobei die erste feuerfeste Schicht, welche direkt über und in Kontakt mit der Substratoberfläche angeordnet ist, aus Ti(C,N), TiN, TiC, Ti(B,C,N), HfN, Zr(C,N) oder Kombinationen davon besteht, wobei vorzugsweise die erste feuerfeste Schicht, welche an die Substratoberfläche angrenzt aus Ti(C,N), besteht.

9. Beschichteter Schneidwerkzeugeinsatz nach einem der vorstehenden Ansprüche, wobei die feuerfeste Schicht, welche direkt unterhalb und in Kontakt mit der $\alpha$-Al$_2$O$_3$ Schicht angeordnet ist, aus kubischem (Ti,Al)N oder kubischem (Ti,Al)(C,N) oder aus einer Mehrlagen-Struktur, bestehend aus abwechselnd kubischen (Ti,Al)N- oder kubischen (Ti,Al)(C,N)-Lagen und einer oder mehreren feuerfesten Schichten aus Carbid, Nitrid, Carbonitrid, Oxycarbonitrid oder Borcarbonitrid von einem oder mehreren von, Ti, Zr, V und Hf oder Kombinationen davon besteht.

10. Beschichteter Schneidwerkzeugeinsatz nach einem der vorstehenden Ansprüche, wobei das Substrat aus Hartmetall, vorzugsweise aus Hartmetall bestehend aus 4 bis 12 Gew.-% Co, optional 0,3-10 Gew.-% kubischen Carbiden, Nitriden oder Carbonitriden der Metalle der Gruppen IVb, Vb und VIb des Periodensystems, vorzugsweise Ti, Nb, Ta oder Kombinationen davon und Rest WC besteht.

11. Beschichteter Schneidwerkzeugeinsatz nach einem der vorstehenden Ansprüche, wobei das Substrat aus Hartmetall besteht, welches eine mit Binderphase angereicherte Oberflächenzone aufweist, mit einer Dicke von 5 bis 30 $\mu$m, vorzugsweise von 10 bis 25 $\mu$m von der Substratoberfläche, wobei die mit Binderphase angereicherte Oberflächenzone einen Co-Gehalt aufweist, welcher mindestens 1,5-mal höher ist als im Kern des Substrates, und einen Gehalt an kubischen Carbiden aufweist, welcher weniger als 0,5 mal des Gehaltes der kubischen Carbide in dem Kern des Substrates ist.

12. Verfahren zur Herstellung eines beschichteten Schneidwerkzeugeinsatzes, vorzugsweise nach einem der vorstehenden Ansprüche, welches die Schritte Beschichten eines Substrates aus Hartmetall, Cermet, Keramik, Stahl oder kubischem Bornitrid mit einer Beschichtung mit einer Gesamtdicke von maximal 60 $\mu$m, bestehend aus einer oder mehreren feuerfesten Schichten, welche eine äußere verschleißfeste Schicht aus $\alpha$-Al$_2$O$_3$ mit einer Dicke von 2 bis 45 $\mu$m, abgeschieden durch chemische Dampfphasenabscheidung (CVD) von einem Reaktionsgasgemisch, welches H$_2$, CO$_2$, AlCl$_3$, HCl und X aufweist, wobei X aus H$_2$S, SF$_6$, SO$_2$ und Kombinationen davon ausgewählt ist, und das Reaktionsgasgemisch weiterhin wahlweise Zugaben von N$_2$, Ar, CO oder Kombinationen davon aufweist, **dadurch gekennzeichnet, dass** der Abscheidungsprozess der $\alpha$-Al$_2$O$_3$-Schicht die Schritte des periodischen Wechselns der Verfahrensbedingungen aufweist, so dass die $\alpha$-Al$_2$O$_3$-Schicht mindestens 3 mal abgeschieden wird, wobei die Verfahrensbedingungen ausgewählt sind aus denjenigen, welche, wenn sie angewendet werden, um eine einzelne $\alpha$-Al$_2$O$_3$-Schicht mit einer Dicke von mindestens 4 $\mu$m abzulagern, geeignet sind, um eine $\alpha$-Al$_2$O$_3$-Schicht abzulagern, welche einen Texturkoeffizienten TC(h k l) > 3 hat, wobei der Texturkoeffizient ausgewählt ist aus TC(0 0 12), TC(1 0 0), TC(1 1 0), TC(1 0 4) und TC(0 1 2) und wie folgt definiert ist:

$$TC(h\,k\,l) = \frac{I(h\,k\,l)}{I_0(h\,k\,l)}\left[\frac{1}{n}\sum_{n-1}^{n}\frac{I(hkl)}{I_0(hkl)}\right]^{-1}$$

wobei

I (h k l) = gemessene Intensität der (hkl)Reflexion

I$_0$ (h k l) = Standardintensität der Standardpulverdiffraktionsdaten gemäß JCPDF-Karte Nr. 42-1468

n = Anzahl der in der Berechnung benutzten Reflexionen, wobei die benutzten (hkl)-Reflexionen (0 1 2), (1 0 4), (1 1 0), (1 1 3), (1 1 6), (3 0 0) und (0 0 12) sind,

wobei eine Veränderung von einer Verfahrensbedingung zu einer anderen Verfahrensbedingung in einer Richtungsänderung der Wachstumsrichtung der $\alpha$-Al$_2$O$_3$-Korngrenzen resultiert, wobei jede Richtungsänderung zweier benachbarter Abschnitte derselben Korngrenze in einem Winkel von 15 bis 165 Grad, vorzugsweise von 30 bis 150 Grad, mehr bevorzugt von 45 bis 135 Grad stattfindet, was in einer SEM-Mikrophotographie eines Querschnitts der $\alpha$-Al$_2$O$_3$-Schicht für mindestens 1 von 25 $\alpha$-Al$_2$O$_3$-Körnern, vorzugsweise mindestens 5 von 25 $\alpha$-Al$_2$O$_3$-Körnern, mehr bevorzugt mindestens 15 von 25 $\alpha$-Al$_2$O$_3$-Körnern beobachtet werden kann.

13. Verfahren nach Anspruch 12, wobei das Ablagerungsverfahren der $\alpha$-Al$_2$O$_3$-Schicht die Schritte des periodischen Wechselns der Verfahrensbedingungen zum Abscheiden von $\alpha$-Al$_2$O$_3$ zwischen zwei unterschiedlichen Verfahrensbedingungen umfasst, wobei die erste Verfahrensbedingung aus einer der Verfahrensbedingungen ausgewählt ist, welche geeignet sind, um eine $\alpha$-Al$_2$O$_3$-Schicht mit einem Texturkoeffizienten TC(h k l) > 3 abzuscheiden, wobei der Texturkoeffizient ausgewählt ist aus TC(0 0 12), TC(1 0 0), TC(1 1 0), TC(1 0 4) und TC(0 1 2), und die zweite Verfahrensbedingung ausgewählt ist aus einer der Verfahrensbedingungen, welche geeignet sind, um eine $\alpha$-Al$_2$O$_3$-Schicht abzuscheiden, welche einen Texturkoeffizienten TC(h k l) > 3 hat, wobei der Texturkoeffizient ausgewählt ist aus TC(0 0 12), TC(1 0 0), TC(1 1 0), TC(1 0 4) und TC(0 1 2), wobei die erste Verfahrensbedingung vorzugsweise eine Verfahrensbedingung ist, welche geeignet ist, um eine $\alpha$-Al$_2$O$_3$-Schicht abzuscheiden, welche einen Texturkoeffizienten TC(0 0 12) > 3 hat, und die zweite Verfahrensbedingung eine Verfahrensbedingung ist, welche geeignet ist, um eine $\alpha$-Al$_2$O$_3$-Schicht abzuscheiden, welche einen Texturkoeffizienten TC(1 1 0) > 3 hat.

14. Verfahren nach einem der Ansprüche 12 bis 13, wobei die Abscheidungszeit für jede Abscheidungsverfahrensbedingung innerhalb des Bereichs von 5 min bis 180 min liegt, vorzugsweise innerhalb des Bereichs von 10 min bis 60 min, und/oder während des Abscheidungsverfahrens der $\alpha$-Al$_2$O$_3$-Schicht die Verfahrensbedingungen zwischen 3 bis 100 mal gewechselt werden, vorzugsweise von 4 bis 80 mal, besonders bevorzugt von 5 bis 60 mal.

**Revendications**

1. Insert d'outil de coupe revêtu constitué d'un substrat en carbure cémenté, en cermet, en céramique, en acier ou en nitrure de bore cubique, sur lequel est déposé un revêtement ayant une épaisseur totale maximale de 60 $\mu$m constitué d'une ou plusieurs couches réfractaires comprenant une couche extérieure résistante à l'usure en $\alpha$-Al$_2$O$_3$ ayant une épaisseur de 2 à 45 $\mu$m déposée par déposition chimique en phase vapeur (CVD),

**caractérisé en ce que**
lorsqu'on l'observe sur une microphotographie MEB d'une section transversale de la couche d'$\alpha$-Al$_2$O$_3$,
la couche d'$\alpha$-Al$_2$O$_3$ a une structure de grains d'$\alpha$-Al$_2$O$_3$ essentiellement basaltique, et
les joints de grains d'au moins 1 grain d'$\alpha$-Al$_2$O$_3$ sur 25, de préférence au moins 5 grains d'$\alpha$-Al$_2$O$_3$ sur 25, mieux encore au moins 15 grains d'$\alpha$-Al$_2$O$_3$ sur 25, le long de la longueur des joints de grains, subissent au moins 3, de préférence 4, mieux encore au moins 5 changements directionnels, chaque changement directionnel de deux sections voisines du même joint de grains étant à un angle de 15 à 165 degrés, de préférence de 30 à 150 degrés, mieux encore de 45 à 135 degrés.

2. Insert d'outil de coupe revêtu selon la revendication 1, dans lequel la distance de pic à pic, mesurée le long de la perpendiculaire à la surface du substrat, entre un changement directionnel et le changement directionnel suivant du même joint de grains, est de 0,05 à 4 $\mu$m, de préférence de 0,1 à 3 $\mu$m, mieux encore de 0,2 à 2 $\mu$m, et/ou la distance de pic à pic, mesurée parallèlement à la surface du substrat, entre un changement directionnel et le changement directionnel suivant du même joint de grains, est de 0,05 à 4 $\mu$m, de préférence de 0,1 à 3 $\mu$m, mieux encore de 0,2 à 2 $\mu$m.

3. Insert d'outil de coupe revêtu selon l'une quelconque des revendications précédentes, dans lequel au moins 70 %, de préférence au moins 80 %, mieux encore au moins 90 %, des cristaux d'$\alpha$-Al$_2$O$_3$ s'étendant vers la surface extérieure de la couche d'$\alpha$-Al$_2$O$_3$, sont terminés par des facettes perpendiculaires à un axe de l'ordre de 0 à 35 degrés, de préférence de l'ordre de 0 à 20 degrés, mieux encore de l'ordre de 0 à 10 degrés par rapport à la perpendiculaire de la surface du substrat, ces facettes terminant les cristaux d'$\alpha$-Al$_2$O$_3$ étant de préférence des plans cristallographiques {0 0 1}.

4. Insert d'outil de coupe revêtu selon l'une quelconque des revendications précédentes, dans lequel la surface extérieure de la couche d'$\alpha$-Al$_2$O$_3$ dans son état tel que déposé et non sablé a les caractéristiques suivantes de rugosité de surface :

i) une rugosité de surface Ra de 0,05 à 0,2 $\mu$m, de préférence de 0,05 à 0,15 $\mu$m, quand la couche d'$\alpha$-Al$_2$O$_3$ a une épaisseur de 8 $\mu$m ou plus ;
ii) une rugosité de surface Ra de 0,03 à 0,2 $\mu$M, de préférence de 0,03 à 0,10 $\mu$m, quand la couche d'$\alpha$-Al$_2$O$_3$ a une épaisseur inférieure à 8 $\mu$m,

la rugosité de surface étant mesurée sur la couche d'$\alpha$-Al$_2$O$_3$ dans son état tel que déposé sans couches de finition et sans post-traitement.

5. Insert d'outil de coupe revêtu selon l'une quelconque des revendications précédentes, dans lequel la texture globale des fibres de toute la couche d'$\alpha$-Al$_2$O$_3$ est **caractérisée par** un coefficient de texture TC (0 0 0 12) > 3, le TC (0 0 0 12) étant défini comme suit :

$$TC(0\,0\,12) = \frac{I(0\,0\,12)}{I_0(0\,0\,12)}\left[\frac{1}{n}\sum_{n=1}^{n}\frac{I(hkl)}{I_0(hkl)}\right]^{-1}$$

ou un coefficient de texture TC (3 3 0) > 3, le TC (3 0 0) étant défini comme suit :

$$TC(3\,0\,0) = \frac{I(3\,0\,0)}{I_0(3\,0\,0)}\left[\frac{1}{n}\sum_{n=1}^{n}\frac{I(hkl)}{I_0(hkl)}\right]^{-1}$$

ou un coefficient de texture TC (1 1 0) > 3, le TC (1 1 0) étant défini comme suit :

$$TC(1\,1\,0) = \frac{I(1\,1\,0)}{I_0(1\,1\,0)}\left[\frac{1}{n}\sum_{n=1}^{n}\frac{I(hkl)}{I_0(hkl)}\right]^{-1}$$

ou un coefficient de texture TC (1 0 4) > 3, le TC (1 0 4) étant défini comme suit :

$$TC(1\,0\,4) = \frac{I(1\,0\,4)}{I_0(1\,0\,4)}\left[\frac{1}{n}\sum_{n-1}^{n}\frac{I(hkl)}{I_0(hkl)}\right]^{-1}$$

ou un coefficient de texture TC (0 1 2) > 3, le TC (0 1 2) étant défini comme suit :

$$TC(0\,1\,2) = \frac{I(0\,1\,2)}{I_0(0\,1\,2)}\left[\frac{1}{n}\sum_{n-1}^{n}\frac{I(hkl)}{I_0(hkl)}\right]^{-1}$$

où

I (h k l) = intensité mesurée de la réflexion (hkl)
$I_0$ (h k l) = intensité standard des données de diffraction standard par la technique des poudres conformément à JCPDF-carte N° 42-1468
n = nombre de réflexions utilisées dans le calcul, les réflexions (hkl) utilisées étant : (0 1 2), (1 0 4), (1 1 0), (1 1 3), (1 1 6), (3 0 0) et (0 0 12).

6. Insert d'outil de coupe revêtu selon l'une quelconque des revendications précédentes, dans lequel le revêtement comprend un revêtement de finition ayant une épaisseur comprise entre 0,1 et 3 $\mu$m, de préférence entre 0,2 et 2 $\mu$m, mieux encore entre 0,5 et 1,5 $\mu$m, par CVD au-dessus de la couche d'$\alpha$-Al$_2$O$_3$, la couche de finition étant constituée de couches de TiN, TiC, TiCN, ZrN, ZrCN, HfN, HfCN, VC, TiAlN, TiAlCN, AlN ou de combinaisons ou multicouches de celles-ci.

7. Insert d'outil de coupe revêtu selon l'une quelconque des revendications précédentes, dans lequel le revêtement comprend une ou plusieurs couches réfractaires sur le substrat et sous la couche d'$\alpha$-Al$_2$O$_3$, la ou les couches réfractaires constituées de carbure, nitrure, carbonitrure, oxycarbonitrure ou borocarbonitrure d'un ou plusieurs parmi Ti, Al, Zr, V et Hf, ou de combinaisons de ceux-ci, étant déposée par déposition chimique en phase vapeur (CVD) ou déposition chimique en phase vapeur à température modérée (MT-CVD), et chaque couche réfractaire ayant une épaisseur de 0,5 à 20 $\mu$m, de préférence de 1 à 10 $\mu$m.

8. Insert d'outil de coupe revêtu selon l'une quelconque des revendications précédentes, dans lequel la première couche réfractaire immédiatement au-dessus de et en contact avec la surface du substrat est constituée de Ti(C,N), TiN, TiC, Ti(B,C,N), HfN, Zr(C,N) ou de combinaisons de ceux-ci, de préférence la première couche réfractaire adjacente à la surface du substrat est constituée de Ti(C,N).

9. Insert d'outil de coupe revêtu selon l'une quelconque des revendications précédentes, dans lequel la couche réfractaire immédiatement sous et en contact avec la couche d'$\alpha$-Al$_2$O$_3$ est constituée de (Ti,Al)N cubique ou de (Ti,Al)(C,N) cubique ou d'une structure multicouche constituée de couches alternées de (Ti,Al)N cubique ou de (Ti,Al)(C,N) cubique et d'une ou plusieurs couches réfractaires constituées de carbure, nitrure, carbonitrure, oxycarbonitrure ou borocarbonitrure d'un ou plusieurs parmi Ti, Zr, V et Hf, ou de combinaisons de ceux-ci.

10. Insert d'outil de coupe revêtu selon l'une quelconque des revendications précédentes, dans lequel le substrat est constitué de carbure cémenté, de préférence de carbure cémenté constitué de 4 à 12 % en poids de Co, éventuellement 0,3 à 10 % en poids de carbures, nitrures ou carbonitrures cubiques de métaux des Groupes IVb, Vb et VIb du Tableau Périodique, de préférence Ti, Nb, Ta ou leurs combinaisons, le reste étant du WC.

11. Insert d'outil de coupe revêtu selon l'une quelconque des revendications précédentes, dans lequel le substrat est constitué de carbure cémenté comprenant une zone de surface enrichie en phase liante ayant une épaisseur de 5 à 30 $\mu$m, de préférence de 10 à 25 $\mu$m, à partir de la surface du substrat, la zone de surface enrichie en phase liante ayant une teneur en Co qui est au moins 1,5 fois supérieure à celle du coeur du substrat et ayant une teneur en carbures cubiques qui est inférieure à 0,5 fois la teneur en carbures cubiques du coeur du substrat.

12. Procédé pour fabriquer un insert d'outil de coupe revêtu, de préférence selon l'une quelconque des revendications précédentes, comprenant les étapes consistant à revêtir un substrat de carbure cémenté, cermet, céramique, acier ou nitrure de bore cubique avec un revêtement ayant une épaisseur totale maximale de 60 $\mu$m constitué d'une ou plusieurs couches réfractaires comprenant une couche extérieure résistante à l'usure en $\alpha$-Al$_2$O$_3$ ayant une épaisseur de 2 à 45 $\mu$m déposée par déposition chimique en phase vapeur (CVD) à partir d'un mélange gazeux comprenant H$_2$, CO$_2$, AlCl$_3$, HCl et X, X étant choisi parmi H$_2$S, SF$_6$, SO$_2$ et leurs combinaisons, le mélange gazeux réactionnel comprenant en outre des additions de N$_2$, Ar, CO ou leurs combinaisons,
**caractérisé en ce que**
le procédé de déposition de la couche d'$\alpha$-Al$_2$O$_3$ comprend les étapes consistant à changer périodiquement les conditions de traitement pour déposer l'$\alpha$-Al$_2$O$_3$ au moins 3 fois, les conditions de traitement étant choisies parmi celles qui, lorsqu'elles sont appliquées à la déposition d'une seule couche d'$\alpha$-Al$_2$O$_3$ ayant une épaisseur d'au moins 4 $\mu$m, sont utiles pour déposer une couche d'$\alpha$-Al$_2$O$_3$ ayant un coefficient de texture TC (h k 1) > 3, le coefficient de texture étant choisi parmi TC (0 0 12), TC (1 0 0), TC (1 1 0), TC (1 0 4) et TC (0 1 2) et étant défini comme suit :

$$TC(h\,k\,l) = \frac{I(h\,k\,l)}{I_0(h\,k\,l)} \left[ \frac{1}{n} \sum_{n=1}^{n} \frac{I(hkl)}{I_0(hkl)} \right]^{-1}$$

où

I (h k l) = intensité mesurée de la réflexion (hkl)
I$_0$ (h k l) = intensité standard des données de diffraction standard par la technique des poudres conformément à JCPDF-carte N° 42-1468
n = nombre de réflexions utilisées dans le calcul, les réflexions (hkl) utilisées étant : (0 1 2), (1 0 4), (1 1 0), (1 1 3), (1 1 6), (3 0 0) et (0 0 12),

dans lequel un changement d'une condition de traitement à une autre condition de traitement a pour résultat un changement directionnel de la direction de croissance des joints de grains d'$\alpha$-Al$_2$O$_3$, chaque changement directionnel de deux sections voisines du même joint de grains étant à un angle de 15 à 165 degrés, de préférence de 30 à 150 degrés, mieux encore de 45 à 135 degrés, que l'on peut observer sur une microphotographie MEB d'une section transversale de la couche d'$\alpha$-Al$_2$O$_3$ pour au moins 1 grain d'$\alpha$-Al$_2$O$_3$ sur 25, de préférence au moins 5 grains d'$\alpha$-Al$_2$O$_3$ sur 25, mieux encore au moins 15 grains d'$\alpha$-Al$_2$O$_3$ sur 25.

13. Procédé selon la revendication 12, dans lequel le procédé de déposition de la couche d'$\alpha$-Al$_2$O$_3$ comprend deux étapes consistant à changer périodiquement les conditions de traitement pour déposer de l'$\alpha$-Al$_2$O$_3$ entre deux conditions de traitement différentes, la première condition de traitement étant choisie parmi l'une des conditions de traitement utiles pour déposer une couche d'$\alpha$-Al$_2$O$_3$ ayant un coefficient de texture TC (h k 1) > 3, le coefficient de texture étant choisi parmi TC (0 0 12), TC (1 0 0), TC (1 1 0), TC (1 0 4) et TC (0 0 1 2), et la deuxième condition de traitement étant choisie parmi l'une des conditions de traitement utiles pour déposer une couche d'$\alpha$-Al$_2$O$_3$ ayant un coefficient de texture TC (h k 1) > 3, le coefficient de texture étant choisi parmi TC (0 0 12), TC (1 0 0), TC (1 1 0), TC (1 0 4) et TC (0 1 2), de préférence la première condition de traitement étant une condition de traitement utile pour déposer une couche d'$\alpha$-Al$_2$O$_3$ ayant un coefficient de texture TC (0 0 12) > 3, et la deuxième condition de traitement étant une condition de traitement utile pour déposer une couche d'$\alpha$-Al$_2$O$_3$ ayant un coefficient de texture TC (1 1 0) > 3.

14. Procédé selon l'une quelconque des revendications 12 et 13, dans lequel le temps de déposition pour chaque condition de traitement de déposition est situé dans la plage allant de 5 minutes à 180 minutes, de préférence dans la plage allant de 10 minutes à 60 minutes, et/ou, durant le procédé de déposition de la couche d'$\alpha$-Al$_2$O$_3$, les conditions de traitement sont changées 3 à 100 fois, de préférence 4 à 80 fois, mieux encore 5 à 60 fois.

_**Figure 1**_

| 2 µm | EHT = 2.50 kV | Signal A = SE2 | Mag = 10.00 K X | —ıılııWALTER |
| | WD = 4.2 mm | File Name = BP1_WAS17_Bü11i_02.tif | | |

_Figure 2_

| 1 μm | EHT = 2.50 kV | Signal A = SE2 | Mag = 10.00 K | WALTER |
| | WD = 3.6 mm | File Name = TA184_2_20120126_15i_13.tif | | |

*Figure 3*

| 1 µm | EHT = 2.50 kV | Signal A = SE2 | Mag = 9.09 K X | |
| |———| | WD = 5.1 mm | File Name = 6TA182.1_B.20120113_15i_06.tif | WALTER |

*Figure 4*

*Figure 5*

**Figure 6**

**Figure 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5137774 A
- US 5654035 A
- US 5980988 A
- US 7442431 B
- US 5863640 A
- US 6333103 B
- US 6869668 B
- US 7094447 B
- US 7442432 B

- US 7455900 B
- US 7993742 B
- US 7923101 B
- US 7763346 B
- US 7201956 B
- US 2012003452 A
- US 7597511 B
- WO 2013038000 A1

**Non-patent literature cited in the description**

- **M. M. NOWELL et al.** *Microscopy Today,* 2005, 44-48